# EUROPEAN PATENT APPLICATION

(11) **EP 1 887 425 A1**
(43) Date of publication of application: **13.02.2008**
(21) Application number: 06747034.4
(22) Date of filing: 31.05.2006
(51) Int. Cl.: G03F 7/031, C08F 2/50, C08F 299/00, G03F 7/004, G03F 7/027, H05K 3/28

(54) **PHOTOCURING/THERMOSETTING RESIN COMPOSITION, CURING/SETTING PRODUCT THEREOF AND PRINTED WIRING BOARD OBTAINED USING THE SAME**

(30) Priority: 31.05.2005 JP 2005160057; 26.12.2005 JP 2005371215; 12.01.2006 JP 2006004687; 27.01.2006 JP 2006018327
(71) Applicant: Taiyo Ink Manufacturing Co. Ltd, Nerima-ku, Tokyo 176-8508 (JP)
(72) Inventor: KATO, Kenji Taiyo Ink Manufacturing Co., Ltd., Hiki-gun, Saitama 355-0222 (JP); SHIBASAKI, Yoko Taiyo Ink Manufacturing Co., Ltd., Hiki-gun, Saitama 355-0222 (JP); ARIMA, Masao Taiyo Ink Manufacturing Co., Ltd., Hiki-gun, Saitama 355-0222 (JP); MINEGISHI, Shouji Taiyo Ink Manufacturing Co., Ltd., Hiki-gun, Saitama 355-0222 (JP)
(74) Representative: HOFFMANN EITLE
(86) International application number: PCT/JP2006/310861
(87) International publication number: WO 2006/129697

(57) **Abstract**

A photocurable and thermosetting resin composition comprising (A) a carboxyl-group containing resin, (B) an oxime ester-based photopolymerization initiator containing an oxime ester group, (C) an aminoacetophenone-based photopolymerization initiator and/or a phosphine oxide-based photopolymerization initiator, (D) a compound having at least two ethylenically unsaturated groups in its molecule, (E) a filler, and (F) a thermosetting component is capable of being developed with a dilute alkaline solution and cured with a laser emission source having a maximum wavelength of 350 nm to 420 nm.

## Description

### Technical Field

This invention relates to a photocurable and thermosetting resin composition useful as an insulating resin layer of a printed circuit board which requires a solder resist and various electronic parts, a cured product thereof, and a printed circuit board obtained using the same. More particularly, the present invention relates to a photocurable and thermosetting resin composition which is capable of curing by the use of a laser emission source having a maximum wavelength of 350-420 nm, a cured product thereof, and a printed circuit board obtained using the same.

### Background Art

A solder resist film is formed in the outermost layer of a printed circuit board of an electronic device. The solder resist is a protective coating material which is used to cover the surface of a printed circuit board therewith to prevent the covering with solder and to prevent molten solder from adhering to irrelevant circuit surfaces at the time of surface mounting of parts. Further, it is used as a permanent protection mask which should have an insulator function to protect the conductor circuit of a printed circuit board from humidity, dust, etc. and also to protect the circuit from an electric trouble and which should be excelling in resistance to chemicals and resistance to heat and also should withstand a high temperature at the time of soldering and gold plating. A method of forming a solder resist generally used is a photolithography method which comprises forming a coating film of a photocurable and thermosetting resin composition on a substrate, and irradiating the coating film with an active energy ray through a photomask having a predetermined exposure pattern formed in advance therein to form a pattern.

In recent years, a direct imaging system (laser direct imaging) using a laser beam as a light source is put into a practical use as a photolithography method considering environmental problems, such as saving resources or energy saving. The direct imaging equipment is a device for depicting an image in a film of the photocurable resin composition, which is sensitive to laser beams, formed in advance on a printed circuit board by directly irradiating with laser beams at high speed according to a pattern datum. This equipment has a characteristic feature of not requiring the use of a mask pattern and thus allows the curtailment of the processing steps and considerable reduction in cost. Accordingly, it is suitable for the production of the multi-kind products in a small lot with short time for delivery.

Since the direct imaging equipment cannot perform the exposure of all the surfaces of the exposing areas simultaneously, unlike the conventional exposure through a mask pattern, the exposure is carried out by turning on and turning off the shutter of laser while selecting the exposing areas and the non-exposing areas one after another. Therefore, in order to attain the exposure time corresponding to the conventional mask pattern exposure, it is necessary to perform the exposure at high speed. Furthermore, a light source currently used for the conventional mask pattern exposure is a metal halide lamp or the like having a wide wavelength as 300-500 nm. On the contrary, in the case of the direct imaging equipment, a semiconductor laser is generally used as a light source, though its light source and wavelength are changed according to the application of the photocurable resin composition to be used, and in many cases the wavelength to be used is in the region of 350-370 nm or in the region of 400-420 nm.

When the conventional solder resist is exposed by the use of the direct imaging equipment of the wavelength of 350-370 nm or 400-420 nm, however, it is not possible to form a coating film which is capable of enjoying the heat resistance and the insulating properties required for a solder resist. The reason for this fact will be considered as follows. As a photopolymerization initiator added to the conventional solder resist, benzyl, benzoin ether, Michler's ketone, anthraquinone, acridine, phenazine, benzophenone, and α-acetophenone-based initiator are used. Since these compounds exhibit low absorption of light having the wavelength of 350-370 nm or 400-420 nm, they are not able to sufficiently initiate the photopolymerization with the light of a single wavelength and thus require a very long exposure time. Accordingly, the application range of the photocurable composition containing the conventional photopolymerization initiator has been limited remarkably.

Under the above circumstances, a photopolymerization initiator which is capable of easily initiating the photopolymerization with the light of a single wavelength only and a composition containing such a photopolymerization initiator have been proposed (see JP 2001-235858,A and WO 02/096969A, for example). Although the technology disclosed in these patent publications will allow sufficient photopolymerization capability to be exhibited with the light of a single wavelength only, however, it is not possible to attain the photo-curing properties in a deep portion and the photo-curing properties in a surface portion simultaneously. Further, they entailed the disadvantage that the sensitivity will decrease remarkably after a heat treatment owing to the deactivation of the photopolymerization initiator on a circuit, thereby having the possibility of causing exfoliation of a coating film on a copper circuit.

Moreover, since the image formation by the direct imaging with a laser beam is generally performed under atmospheric conditions, the reaction will be easily inhibited by oxygen. Therefore, in the developing process for removing an unnecessary portion after exposure, the surface part of the resist in a required portion will be removed, thereby posing a problem of easily causing poor gloss as a result. In the solder resist aiming at the protection of a printed circuit board, insufficient gloss will pose the problems of not only the poor appearance but also the deterioration of resistance to chemicals and electrical properties in the surface of the film due to the insufficient reaction at the portion in which the reaction should proceed enough.

### Disclosure of the Invention

### Problems to be Solved by the Invention

The present invention aims at providing a photocurable and thermosetting resin composition which is capable of exhibiting high photopolymerization capability with a laser beam of 350-420 nm, enjoying sufficient photo-curing properties in a deep portion of a coating film, and excelling in heat stability, particularly a photocurable and thermosetting resin composition suitable for use as a solder resist and in the direct imaging with a laser beam of 350-420nm, and also providing a cured product thereof as well as a printed circuit board having a pattern formed by the use thereof.

### Means for Solving the Problems

To accomplish the objects mentioned above, the present invention provides a photocurable and thermosetting resin composition capable of being developed with a dilute alkaline solution and cured with a laser emission source having a maximum wavelength of 350 nm to 420 nm, comprising (A) a carboxyl-group containing resin, (B) an oxime ester-based photopolymerization initiator containing an oxime ester group represented by the following general formula (I), (C) an aminoacetophenone-based photopolymerization initiator (C-1) containing the structure represented by the following general formula (II) and/or a phosphine oxide-based photopolymerization initiator (C-2) containing the structure represented by the following general formula (III), (D) a compound having at least two ethylenically unsaturated groups in its molecule, (E) a filler, and (F) a thermosetting component.

### [Formula 1]

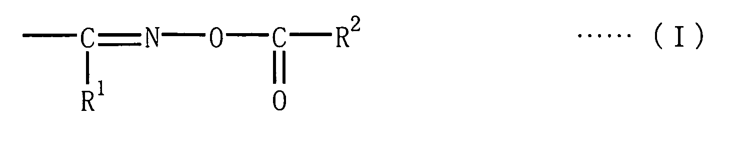

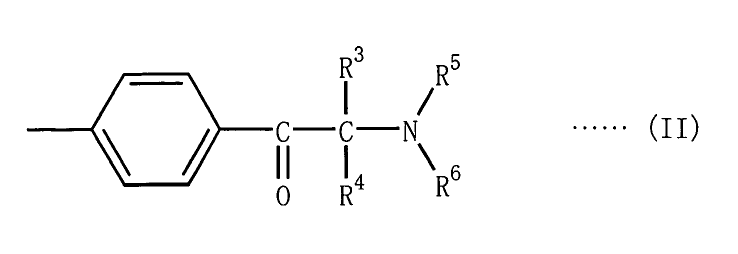

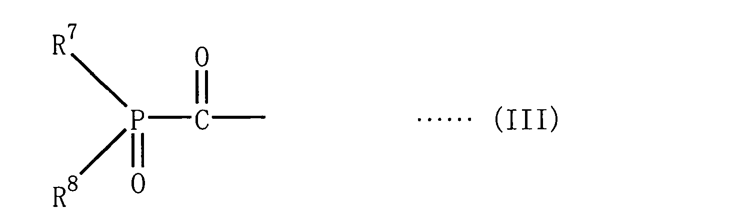

wherein R¹ represents a hydrogen atom, an alkyl group of 1-7 carbon atoms, or a phenyl group, R² represents an alkyl group of 1-7 carbon atoms or a phenyl group, R³ and R⁴ independently represent an alkyl group of 1-12 carbon atoms or an arylalkyl group, R⁵ and R⁶ independently represent a hydrogen atom, an alkyl group of 1-6 carbon atoms, or a cyclic alkyl ether group of four carbon atoms formed by R⁵ and R⁶ bonded, and R⁷ and R⁸ independently represent a linear or branched alkyl group of 1-6 carbon atoms, a cyclohexyl group, a cyclopentyl group, an aryl group, a halogen atom, an aryl group substituted by an alkyl group or an alkoxy group, or either one represents an acyl group of 1-20 carbon atoms.

The absorption wavelength of a laser beam differs depending on that either of the aminoacetophenone-based photopolymerization initiator (C-1) containing the structure represented by the general formula (II) mentioned above or the phosphine oxide-based photopolymerization initiator (C-2) containing the structure represented by the general formula (III) mentioned above is used in combination with the oxime ester-based photopolymerization initiator (B) containing an oxime ester group represented by the general formula (I) mentioned above. When the aminoacetophenone-based photopolymerization initiator (C-1) containing the structure represented by the general formula (II) mentioned above is used, the resultant photocurable and thermosetting resin composition is capable of curing with the laser emission source having a maximum wavelength of 350-370 nm. On the other hand, when the phosphine oxide-based photopolymerization initiator (C-2) containing the structure represented by the general formula (III) mentioned above is used, the resultant composition is capable of curing with the laser emission source having a maximum wavelength of 400-420 nm. By using both initiators, the resultant composition is capable of curing with a laser emission source having a maximum wavelength of 350-420 nm.

Therefore, in accordance with one specific embodiment of the present invention, there is provided a photocurable and thermosetting resin composition capable of being developed with a dilute alkaline solution and cured with a laser emission source having the maximum wavelength of 350 to 370 nm, comprising (A) a carboxyl-group containing resin, (B) an oxime ester-based photopolymerization initiator containing an oxime ester group represented by the general formula (I) mentioned above, (C-1) an aminoacetophenone-based photopolymerization initiator containing the structure represented by the general formula (II) mentioned above, (D) a compound having at least two ethylenically unsaturated groups in its molecule, (E) a filler, and (F) a thermosetting component.

In accordance with another specific embodiment of the present invention, there is provided a photocurable and thermosetting resin composition capable of being developed with a dilute alkaline solution and cured with a laser emission source having the maximum wavelength of 400 to 420 nm, comprising (A) a carboxyl-group containing resin, (B) an oxime ester-based photopolymerization initiator containing an oxime ester group represented by the general formula (I) mentioned above, (C-2) a phosphine oxide-based photopolymerization initiator containing the structure represented by the general formula (III) mentioned above, (D) a compound having at least two ethylenically unsaturated groups in its molecule, (E) a filler, and (F) a thermosetting component.

The photocurable and thermosetting resin composition of the present invention may be provided in the form of liquid or in the form of a photosensitive dry film.
According to the present invention, there is further provided a cured product obtained by photo-curing the above-mentioned photocurable and thermosetting resin composition with a laser beam having a wavelength of 350-420 nm, or further thermally curing it, and a printed circuit board having a pattern film formed thereon from the cured product mentioned above.

### Effects of the Invention

The photocurable and thermosetting resin composition of the present invention excels in photo-curing properties in a deep portion of a coating film, is capable of forming a pattern without causing halation and under cut with a laser emission source having a wavelength of 350-420 nm, and therefore is suitable for use as a solder resist for laser direct imaging.
Further, by using such a solder resist for laser direct imaging, there is no need to use a negative pattern, which will contribute to improvement in the initial productivity of a printed circuit board and reduction in cost.
Since the photocurable and thermosetting resin composition of the present invention excels in photo-curing properties in a deep portion of a coating film and exhibits high sensitivity and high resolution, it is possible to provide a reliable printed circuit board.

### Brief Description of the Drawings

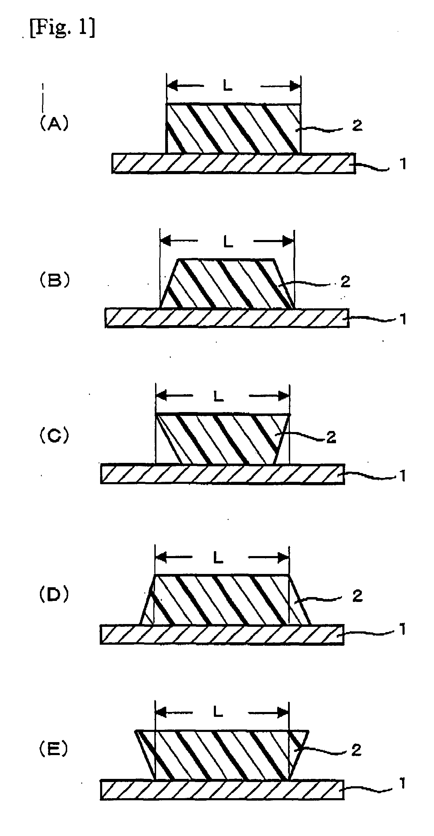

Fig. 1 is a cross-sectional view schematically illustrating the profiles of a pattern film of a photocurable and thermosetting resin composition obtained by exposure to light and development.

### Description of Reference Numerals

1: Substrate
2: Pattern film
L: Designed value of line width

### Best Mode for Carrying Out the Invention

The present inventors, after pursuing a diligent study to accomplish the objects mentioned above, have found that in a photocurable and thermosetting resin composition capable of being developed with a dilute alkaline solution, which comprises (A) a carboxyl-group containing resin, (D) a compound having at least two ethylenically unsaturated groups in its molecule, (E) a filler, and (F) a thermosetting component, when (B) an oxime ester-based photopolymerization initiator containing an oxime ester group represented by the general formula (I) mentioned above is used in combination with (C) an aminoacetophenone-based photopolymerization initiator (C-1) containing the structure represented by the general formula (II) mentioned above and/or a phosphine oxide-based photopolymerization initiator (C-2) containing the structure represented by the general formula (III) mentioned above as photopolymerization initiators, there is obtained a photocurable and thermosetting resin composition which is capable of exhibiting high photopolymerization capability with a laser beam of 350-420 nm, enjoying sufficient photo-curing properties in a deep portion of a coating film, and excelling in heat stability. This discovery has led to perfection of the present invention. Incidentally, the absorption wavelength of a laser beam differs depending on that either of the aminoacetophenone-based photopolymerization initiator (C-1) containing the structure represented by the general formula (II) mentioned above or the phosphine oxide-based photopolymerization initiator (C-2) containing the structure represented by the general formula (III) mentioned above is used in combination with the oxime ester-based photopolymerization initiator (B) containing an oxime ester group represented by the general formula (I) mentioned above. When the aminoacetophenone-based photopolymerization initiator (C-1) containing the structure represented by the general formula (II) mentioned above is used, the resultant photocurable and thermosetting resin composition is capable of curing with a laser emission source having a maximum wavelength of 350-370 nm. On the other hand, when the phosphine oxide-based photopolymerization initiator (C-2) containing the structure represented by the general formula (III) mentioned above is used, the resultant composition is capable of curing with a laser emission source having a maximum wavelength of 400-420 nm. By using both initiators, the resultant composition is capable of curing with a laser emission source having a maximum wavelength of 350-420 nm. Further, even when either of the aminoacetophenone-based photopolymerization initiator (C-1) containing the structure represented by the general formula (II) mentioned above or the phosphine oxide-based photopolymerization initiator (C-2) containing the structure represented by the general formula (III) mentioned above is used, the absorption wavelength of the laser beam can be adjusted by the addition of other photopolymerization initiator or a photo-initiator aid. Particularly, in case the aminoacetophenone-based photopolymerization initiator (C-1) containing the structure represented by the general formula (II) mentioned above is used, the absorption wavelength of the laser beam can be adjusted by the addition of a thioxanthone-based photopolymerization initiator and the resultant composition is capable of curing with the laser emission source having a maximum wavelength of 350-370 nm.

Now, the components of the photocurable and thermosetting resin composition of the present invention will be described in detail below.
As the carboxyl group-containing resin (A) contained in the photocurable and thermosetting resin composition of the present invention, any well-known and widely used resin compounds having a carboxyl group in its molecule may be used. From the viewpoint of the photo-curing properties and resistance to development, a carboxyl group-containing photosensitive resin (A') having further an ethylenically unsaturated double bond in its molecule is preferred.
As concrete examples of the carboxyl group-containing resin, the resins as listed below may be cited.

(1) a carboxyl group-containing copolymer resin obtained by the copolymerization of an unsaturated carboxylic acid such as (meth)acrylic acid with one or more of other compounds having an unsaturated double bond,
(2) a carboxyl group-containing photosensitive copolymer resin obtained by adding an ethylenically unsaturated group of a compound, such as a compound having an epoxy group and an unsaturated double bond like glycidyl (meth)acrylate and 3,4-epoxycyclohexylmethyl (meth)acrylate or (meth)acrylic chloride, as a pendant to a copolymer of an unsaturated carboxylic acid such as (meth)acrylic acid with one or more of other compounds having an unsaturated double bond,
(3) a carboxyl group-containing photosensitive copolymer resin obtained by causing an unsaturated monocarboxylic acid such as (meth)acrylic acid to react with a copolymer of a compound having a epoxy group and an unsaturated double bond, such as glycidyl (meth)acrylate and 3,4-epoxycyclohexylmethyl (meth)acrylate, and one or more of other compounds having an unsaturated double bond, and then causing a polybasic acid anhydride to react with the secondary hydroxyl group caused by the above reaction,
(4) a carboxyl group-containing photosensitive copolymer resin obtained by causing a compound having a hydroxyl group and an unsaturated double bond, such as 2-hydroxyethyl (meth)acrylate, to react with a copolymer of an acid anhydride having an unsaturated double bond, such as maleic anhydride, and other compound having an unsaturated double bond,
(5) a carboxyl group-containing photosensitive resin obtained by causing a polyfunctional epoxy compound to react with an unsaturated monocarboxylic acid and then causing a saturated or unsaturated polybasic acid anhydride to react with the hydroxyl group caused by the above reaction,
(6) a hydroxyl group-containing and carboxyl group-containing photosensitive resin obtained by causing a saturated or unsaturated polybasic acid anhydride to react with a hydroxyl group-containing polymer, such as polyvinyl alcohol derivatives, and then causing a compound having an epoxy group and an unsaturated double bond in its molecule to react with the resultant carboxylic acid,
(7) a carboxyl group-containing photosensitive resin obtained by causing a saturated or unsaturated polybasic acid anhydride to react with a reaction product of a polyfunctional epoxy compound with an unsaturated monocarboxylic acid and a compound containing in its molecule at least one alcoholic hydroxyl group and one reactive group other than the alcoholic hydroxyl group, which can react with an epoxy group,
(8) a carboxyl group-containing photosensitive resin obtained by causing an unsaturated monocarboxylic acid to react with a polyfunctional oxetane compound having at least two oxetane rings in its molecule and then causing a saturated or unsaturated polybasic acid anhydride to react with the primary hydroxyl group of the resultant modified oxetane resin, and
(9) a carboxyl group-containing photosensitive resin obtained by causing a polyfunctional epoxy compound to react with an unsaturated monocarboxylic acid, then causing a polybasic acid anhydride to react with the resultant product, and then further causing a compound having one oxirane ring and one or more ethylenically unsaturated groups in its molecule to react with a carboxyl group-containing resin obtained by the above reaction. The carboxyl group-containing resin is not limited to the resins enumerated above.
   Among other resins enumerated above, the carboxyl group-containing resins (2), (5), (7) and (9) mentioned above, particularly the carboxyl group-containing photosensitive resin (9) mentioned above, prove to be desirable from the viewpoint of the photo-curing properties and the properties of the cured coating film.
   Incidentally, the term "(meth)acrylate" as used in the present specification refers collectively to acrylate, methacrylate and a mixture thereof. This holds good for other similar representation.

Since the carboxyl group-containing resins (A) mentioned above have numerous free carboxyl groups added to the side chains of a backbone polymer, the compositions containing these resins are developable with a dilute aqueous alkaline solution.
The acid value of the carboxyl group-containing resin (A) mentioned above is preferred to be in the range of 40 to 200 mg KOH/g, preferably in the range of 45 to 120 mg KOH/g. If the acid value of the carboxyl group-containing resin is less than 40 mg KOH/g, the development of the composition with an aqueous alkaline solution will be performed only with difficulty. Conversely, if the acid value exceeds 200 mg KOH/g, the dissolving out of the exposed area in a developing solution will proceed, the line width will become narrow unduly, occasionally a coating film is dissolved out in a developing solution and separated from a substrate regardless of the exposed area or unexposed area and, as a result, the formation of a proper resist pattern may be attained only with difficulty.
The weight-average molecular weight of the carboxyl group-containing resin (A) mentioned above is generally desired to fall in the range of 2,000 to 150,000, preferably 5,000 to 100,000, though it varies depending on the skeleton of the resin. If the weight-average molecular weight of the resin is less than 2,000, there is a possibility of impairing the tack-free touch of a coating film applied to a substrate and dried and also resistance to humidity of the coating film after exposure to light, thereby causing reduction in film thickness during the developing process and considerably impairing the resolution. Conversely, if the weight-average molecular weight exceeds 150,000, there is a possibility of impairing the developing properties of the coating film and the storage stability of the composition.
The amount of the carboxyl group-containing resin (A) to be incorporated in the composition is preferred to account for a proportion in the range of 20 to 60% by weight, preferably 30 to 50% by weight, based on the total amount of the composition. If the amount of the carboxyl group-containing resin (A) to be incorporated is unduly smaller than the lower limit of the range mentioned above, undesirably the strength of the coating film formed will decrease. Conversely, if the amount is unduly larger than the upper limit of the range mentioned above, undesirably the viscosity of the composition will become high and the application properties thereof will be deteriorated.

The oxime ester-based photopolymerization initiator (B) to be used in the present invention is an oxime ester-based photopolymerization initiator containing an oxime ester group represented by the following general formula (I), for example, those described in JP 2001-235858,A mentioned hereinbefore may be cited. 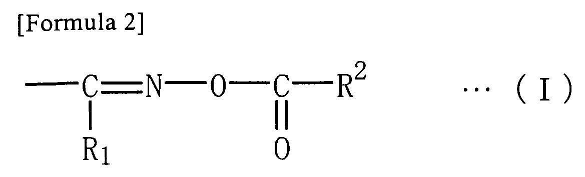 wherein R¹ represents a hydrogen atom, an alkyl group of 1-7 carbon atoms, or a phenyl group, and R² represents an alkyl group of 1-7 carbon atoms or a phenyl group.

A preferred compound of such an oxime ester-based photopolymerization initiator (B) is 2-(acetyloxyiminomethyl) thioxanthen-9-one represented by the following formula (IV). As a commercially available product, CGI-325 manufactured by Ciba Specialty Chemicals K.K. may be cited. 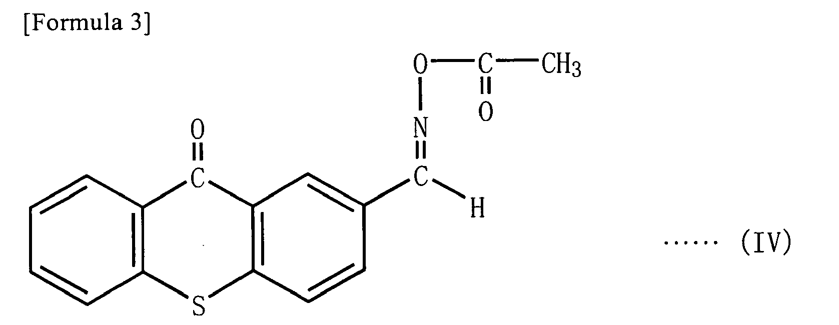 Further, such compounds as 1,2-octane dione, 1-[4-(phenylthio)-, 2-(O-benzoyloxime)] represented by the following formula (V), trade name: Irgacure OXE01 manufactured by Ciba Specialty Chemicals K.K. and ethanone, 1-[9-ethyl-6-(2-methylbenzoyl)-9H-carbazole-3-yl]-, 1-(O-acetyl oxime) represented by the following formula (VI), trade name: Irgacure OXE02 manufactured by Ciba Specialty Chemicals K.K. may be advantageously used.

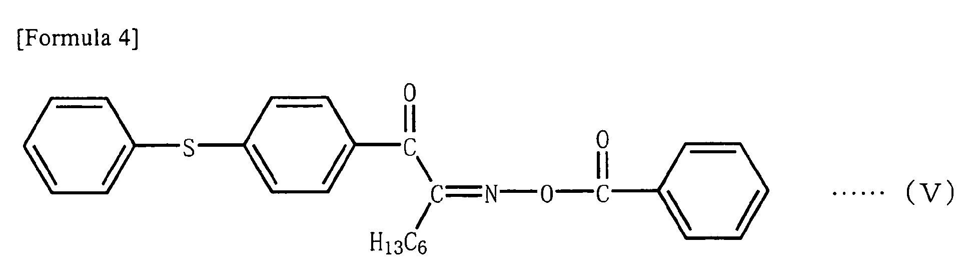

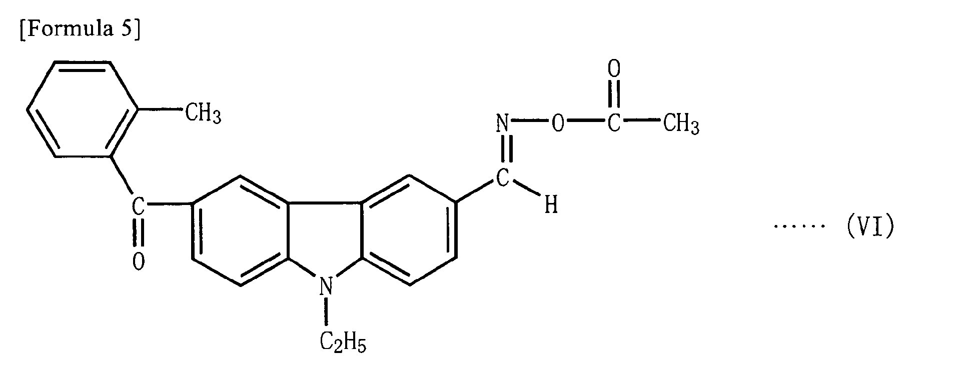

When only the photocurable and thermosetting resin composition containing such an oxime ester-based photopolymerization initiator (B) is applied onto copper of a printed circuit board etc., there is a problem that the photocurable and thermosetting resin composition will react with a copper atom at the interface thereof by the heat at the time of pre-drying, thereby causing deactivation of the function as a photopolymerization initiator. (Even when the composition is heated on copper, photopolymerization thereof will not proceed and heat stability will be inferior.) To this end, according to the present invention, it is necessary to use the above oxime ester-based photopolymerization initiator in combination with the aminoacetophenone-based photopolymerization initiator (C-1) containing the structure represented by the general formula (II) mentioned above and/or the phosphine oxide-based photopolymerization initiator (C-2) containing the structure represented by the general formula (III) mentioned above.

The amount of such an oxime ester-based photopolymerization initiator (B) to be incorporated in the composition is preferred to be in the range of 0.01 to 10 parts by weight, preferably 0.01 to 5 parts by weight, based on 100 parts by weight of the above-mentioned carboxyl-group containing resin (A). If the amount of the oxime ester-based photopolymerization initiator (B) is less than 0.01 part by weight based on 100 parts by weight of the above-mentioned carboxyl-group containing resin (A), it will be hardly possible to proceed the sufficient curing of the photosensitive components (the carboxyl group-containing photosensitivity resin cited as the above-mentioned component (A) and a compound (D) having two or more ethylenically unsaturated groups in its molecule to be described hereinafter) by the light of a wavelength range of 350-420 nm, and accordingly the resistance to humidity of a cured coating film becomes high and PCT resistance tends to become low, and further the resistance to soldering heat and resistance to electroless plating tend to become low. Conversely, if the amount of the oxime ester-based photopolymerization initiator (B) exceeds 20 parts by weight based on 100 parts by weight of the above-mentioned carboxyl-group containing resin (A), the developing properties of a coating film and the resistance to electroless plating of a cured coating film will be deteriorated, and the PCT resistance will also become inferior.

As the aminoacetophenone-based photopolymerization initiator (C-1) having the structure represented by the following general formula (II) to be used in the present invention, for example, 2-methyl-1-[4-(methylthio)phenyl]-2-morpholinopropanone-1, 2-benzyl-2-dimethylamino-1-(4-morpholinophenyl)-butan-1-one, and N,N-dimethylaminoacetophenone may be cited. As a commercially available product, Irgacure 907 and Irgacure 396 manufactured by Ciba Specialty Chemicals K.K. may be cited. 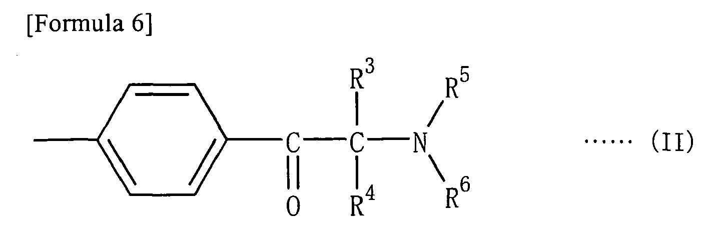 wherein R³ and R⁴ independently represent an alkyl group of 1-12 carbon atoms or an arylalkyl group, and R⁵ and R⁶ independently represent a hydrogen atom, an alkyl group of 1-6 carbon atoms, or a cyclic alkyl ether group of four carbon atoms formed by R⁵ and R⁶ bonded.
Such an aminoacetophenone-based photopolymerization initiator (C-1) does not inhibit the polymerization by the above-mentioned oxime ester-based photopolymerization initiator (B) and can compensate the photo-curing properties when the deactivation of the above-mentioned oxime ester-based photopolymerization initiator (B) has occurred in the interface with copper, thereby giving sufficient photo-curing properties even on the copper.

The amount of such an aminoacetophenone-based photopolymerization initiator (C-1) is preferred to be in the range of 0.1 to 30 parts by weight, preferably 0.5 to 15 parts by weight, based on 100 parts by weight of the above-mentioned carboxyl-group containing resin (A). If the amount of the aminoacetophenone-based photopolymerization initiator (C-1) is less than 0.1 part by weight based on 100 parts by weight of the above-mentioned carboxyl-group containing resin (A), the photo-curing properties of the resultant photocurable and thermosetting resin composition on the copper becomes insufficient, thereby undesirably causing the peeling of a coating film or deterioration of the properties of the coating film, such as resistance to chemicals. Conversely, if the amount of the aminoacetophenone-based photopolymerization initiator (C-1) exceeds 30 parts by weight based on 100 parts by weight of the above-mentioned carboxyl-group containing resin (A), undesirably the photo-curing properties in a deep portion will become inferior due to the light absorption by the aminoacetophenone-based photopolymerization initiator (C-1).

As the phosphine oxide-based photopolymerization initiator (C-2) having the structure represented by the following general formula (III) to be used in the present invention, for example, 2,4,6-trimethylbenzoyl-diphenyl phosphine oxide, bis(2,4,6-trimethylbenzoyl)-phenyl phosphine oxide, and bis(2,6-dimethoxybenzoyl)-2,4,4-trimethyl-pentyl phosphine oxide may be cited. 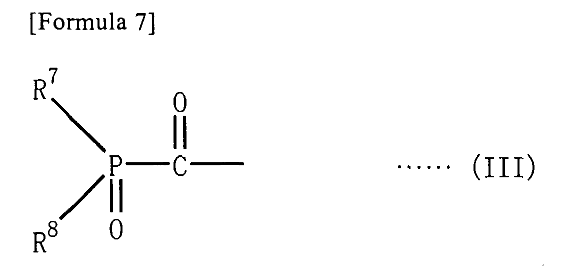 wherein R⁷ and R⁸ independently represent a linear or branched alkyl group of 1-6 carbon atoms, a cyclohexyl group, a cyclopentyl group, an aryl group, a halogen atom, an aryl group substituted by an alkyl group or an alkoxy group, or either one represents an acyl group of 1-20 carbon atoms (preferably a benzoyl group having an alkyl group of 2-12 carbon atoms).
Such a phosphine oxide-based photopolymerization initiator (C-2) does not inhibit the polymerization by the above-mentioned oxime ester-based photopolymerization initiator (B) and can compensate the photo-curing properties when the deactivation of the above-mentioned oxime ester-based photopolymerization initiator (B) has occurred in the interface with copper, thereby giving sufficient photo-curing properties even on the copper.

The amount of such a phosphine oxide-based photopolymerization initiator (C-2) is preferred to be in the range of 0.05 to 20 parts by weight, preferably 0.1 to 10 parts by weight, based on 100 parts by weight of the above-mentioned carboxyl-group containing resin (A). If the amount of the phosphine oxide-based photopolymerization initiator (C-2) exceeds 20 parts by weight based on 100 parts by weight of the above-mentioned carboxyl-group containing resin (A), undesirably the photo-curing properties of the resultant photocurable and thermosetting resin composition will be deteriorated when its film thickness is large, thereby leading to the increase in cost of a product.
Further, the amount of the oxime-based photopolymerization initiator (B) represented by the general formula (I) mentioned above is preferred to be smaller than the amount of the aminoacetophenone-based photopolymerization initiator (C-1) containing the structure represented by the general formula (II) mentioned above and the amount of the phosphine oxide-based photopolymerization initiator (C-2) containing the structure represented by the general formula (III) mentioned above in order to attain the photo-curing properties in thick film with high sensitivity.
Incidentally, although the aminoacetophenone-based photopolymerization initiator (C-1) containing the structure represented by the general formula (II) mentioned above acts effectively on the deactivation of the above-mentioned oxime ester-based photopolymerization initiator (B) on a copper foil, if independent, this initiator itself has no absorption wavelength to the laser beam of 400-420 nm, to which the phosphine oxide-based photopolymerization initiator (C-2) containing the structure represented by the general formula (III) mentioned above acts effectively. Thus, as to the laser beam of 400-420 nm, it is desirable to use the above-mentioned oxime ester-based photopolymerization initiator (B) and the above-mentioned phosphine oxide-based photopolymerization initiator (C-2) in combination. Furthermore, the use of the aminoacetophenone-based photopolymerization initiator (C-1) in combination therewith is preferable from the viewpoint of the photo-curing properties in a surface portion of a coating film. When these aminoacetophenone-based photopolymerization initiator (C-1) and phosphine oxide-based photopolymerization initiator (C-2) are used in combination, their proportions are desired to be such a range that the absorbance per 25 µm thickness of a dried coating film in the wavelength region of the laser beam should be in the range of 0.3-1.5, though the ratio is not limited to a particular range.

The photocurable and thermosetting resin composition of the present invention may optionally further incorporate therein a well known and widely used photopolymerization initiator, for example, benzoin and alkyl ethers thereof such as benzoin, benzoin methyl ether, benzoin ethyl ether, and benzoin isopropyl ether; acetophenones such as acetophenone, 2,2-dimethoxy-2-phenyl acetophenone, 2,2-diethoxy-2-phenyl acetophenone, and 1,1-dichloroacetophenone; anthraquinones such as 2-methyl-anthraquinone, 2-ethylanthraquinone, 2-t-butylanthraquinone, and 1-chloroanthraquinone; thioxanthones such as 2,4-dimethylthioxanthone, 2,4-diethylthioxanthone, 2-chlorothioxanthone, 2-isopropylthioxanthone, and 2,4-diisopropylthioxanthone; ketals such as acetophenone dimethyl ketal and benzyl dimethyl ketal; benzophenones such as benzophenone, 4-benzoyldipheny sulfide, 4-benzoyl-4'-methyldipheny sulfide, 4-benzoyl-4'-ethyldipheny sulfide, and 4-benzoyl-4'-propyldipheny sulfide or xanthones; and phosphine oxides such as 2,4,6-trimethylbenzoyl diphenyl phosphine oxide in combination with the above-mentioned photopolymerization initiators (B) and (C-1) and/or (C-2). From the viewpoint of the photo-curing properties in a deep portion of a coating film, the combined use of a thioxanthone-based photopolymerization initiator, such as 2,4-dimethylthioxanthone, 2,4-diethylthioxanthone, 2-chlorothioxanthone, 2-isopropylthioxanthone, and 2,4-diisopropylthioxanthone, proves to be preferable.

Further, the photocurable and thermosetting resin composition of the present invention may incorporate therein a tertiary amine compound and a benzophenone compound as a photo-initiator aid. As such tertiary amines, ethanol amines, 4,4'-dimethylaminobenzophenone (NISSO Cure MABP manufactured by Nippon Soda Co., Ltd.), ethyl 4-dimethylaminobenzoate (Kaya Cure EPA manufactured by Nippon Kayaku Co., Ltd.), ethyl 2-dimethylaminobenzoate (Quantacure DMB manufactured by International Biosynthetic Inc.), (n-butoxy)ethyl 4-dimethylaminobenzoate (Quantacure BEA manufactured by the international Biosynthetic Inc.), isoamylethyl p-dimethylaminobenzoate (Kaya Cure DMBI manufactured by Nippon Kayaku Co., Ltd.), 2-ethylhexyl 4-dimethylaminobenzoate (Esolol 507 manufactured by Van Dyk GmbH), 4,4'-diethylaminobenzophenone (EAB manufactured by Hodogaya Chemical Co., Ltd.), etc. may be cited. These well-known and widely used tertiary amine compounds may be used either singly or in the form of a mixture of two or more members. Although a particularly preferred tertiary amine compound is 4,4'-diethylaminobenzophenone, it is not limited to this compound. Any compounds which absorb light in the region of a wavelength of 350-420 nm and exhibits a sensitizing effect when used in combination with a hydrogen extracting type photopolymerization initiator may be used either singly or in the form of a combination of two or more members irrespective of the photopolymerization initiator or the photo-initiator aid. A particularly preferred compound is 4,4'-diethylaminobenzophenone (EAB manufactured by Hodogaya Chemical Co., Ltd.).

The amount of the photopolymerization initiator and the photo-initiator aid to be incorporated in the composition is preferred to be in such a range that the total amount including the above-mentioned oxime ester-based photopolymerization initiator (B) and the aminoacetophenone-based photopolymerization initiator (C-1) and/or the phosphine oxide-based photopolymerization initiator (C-2) is not more than 35 parts by weight, based on 100 parts by weight of the aforementioned carboxyl group-containing resin (A), preferably in such a range that the absorbance per 25 µm thickness of a dried coating film formed from a composition containing a coloring pigment to be described hereinafter at the wavelength of 355 nm or 405 nm should be in the range of 0.3-1.5, preferably 0.5-1.2. If the amount exceeds the upper limit of the range mentioned above, the photo-curing properties in a deep portion of a coating film of the resultant photocurable and thermosetting resin composition will become inferior due to the light absorption by the photopolymerization initiator mentioned above. Conversely, if the amount is less than the lower limit of the range mentioned above, undesirably the photo-curing properties in a surface portion will become inferior and halation will easily occur.

The compound (D) having two or more ethylenically unsaturated groups in its molecule used for the photocurable and thermosetting resin composition of the present invention is capable of curing by irradiation with an active energy ray and insolubilizing the above-mentioned carboxyl group-containing resin (A) in an aqueous alkali solution or assisting the insolubilization. As concrete examples of such a compound, hydroxyalkyl acrylates such as 2-hydroxyethyl acrylate and 2-hydroxypropyl acrylate; mono- or di-acrylates of glycols such as ethylene glycol, methoxytetraethylene glycol, polyethylene glycol, and propylene glycol; acrylamides such as N,N-dimethyl acrylamide, N-methylol acrylamide, and N,N-dimethylaminopropyl acrylamide; aminoalkyl acrylates such as N,N-dimethylaminoethyl acrylate and N,N-dimethylaminopropyl acrylate; polyfunctional acrylates of polyhydric alcohols, such as hexane diol, trimethylol propane, pentaerythritol, dipentaerythritol, and tris-hydroxyethyl isocyanurate, and ethylene oxide adducts or propylene oxide adducts of these polyhydric alcohols; acrylates of phenols and ethylene oxide adducts or propylene oxide adducts of phenols such as phenoxy acrylate and bisphenol A diacrylate; acrylates of glycidyl ethers such as glycerin diglycidyl ether, glycerin triglycidyl ether, trimethylol propane triglycidyl ether, and triglycidyl isocyanurate; melamine acrylate, and/or methacrylates corresponding to the acrylates enumerated above may be cited.
Further, an epoxy acrylate resin obtained by the reaction of a polyfunctional epoxy resin such as a cresol novolak type epoxy resin with acrylic acid, an epoxy urethane acrylate compound obtained by causing a half urethane compound of a hydroxyl acrylate such as pentaerythritol triacrylate and a diisocyanate such as isophorone diisocyanate to react with the hydroxyl group of the epoxy acrylate resin mentioned above, or the like may be cited. Such an epoxy acrylate type resin is capable of improving the photo-curing properties, without deteriorating the tack-free touch of finger of a dried coating film of the resultant photocurable and thermosetting resin composition.

The amount of such a compound (D) having two or more ethylenically unsaturated groups in its molecule to be incorporated in the composition is desired to be in the range of 5 to 100 parts by weight, preferably in the range of 1 to 70 parts by weight, based on 100 parts by weight of the carboxyl group-containing resin (A) mentioned above. If the amount of the compound is less than 5 parts by weight based on 100 parts by weight of the above-mentioned carboxyl group-containing resin (A), undesirably the photo-curing properties of the resultant photocurable and thermosetting resin composition will become inferior, and after irradiation with an active energy ray, it will be difficult to complete the pattern formation with an alkali development. Conversely, if the amount exceeds 100 parts by weight, undesirably the solubility of the composition in an aqueous alkaline solution will become inferior and a coating film will become brittle.

As the filler (E) to be used in the present invention, although any well-known and widely used inorganic or organic fillers may be used, particularly barium sulfate and spherical silica are used preferably. Further, the filler obtained by dispersing the silica of the order of nanometer in the compound (D) having two or more ethylenically unsaturated groups in its molecule mentioned above or a polyfunctional epoxy compound (F-1) to be described hereinafter; NANOCRYL(trade name) XP 0396, XP 0596, XP 0733, XP 0746, XP 0765, XP 0768, XP 0953, XP 0954, and XP 1045 (all product grade names) manufactured by Hanse-Chemie GmbH, and NANOPOX (trade name) XP 0516, XP 0525, and XP 0314 (all product grade names) manufactured by Hanse-Chemie GmbH may be used.
These fillers (E) may be incorporated in the composition either singly or in the combination of two or more members to suppress the shrinkage of a coating film on curing and to improve the basic characteristics of the coating film such as adhesiveness and hardness.

The amount of the filler (E) to be incorporated in the composition is desired to be in the range of 0.1 to 200 parts by weight, preferably 1 to 100 parts by weight, based on 100 parts by weight of the carboxyl group-containing resin (A) mentioned above. If the amount of the filler (E) is less than 0.1 part by weight based on 100 parts by weight of the above-mentioned carboxyl group-containing resin (A), undesirably the photo-curing properties, such as resistance to soldering temperature and resistance to gold plating, of the resultant photocurable and thermosetting resin composition will become inferior. Conversely, if the amount exceeds 200 parts by weight, undesirably the viscosity of the composition will become high, the printability of the composition will become inferior, and the cured product will become brittle.

As the thermosetting component (F) to be used in the present invention, any well-known and widely used thermosetting resins, such as amino resins like a melamine resin and a benzoguanamine resin, blocked isocyanate compounds, cyclocarbonate compounds, polyfunctional epoxy compounds, polyfunctional oxetane compounds, and an episulfide resin may be used. Among other thermosetting components, the thermosetting components having two or more cyclic ether groups and/or cyclic thioether groups in its molecule (hereinafter briefly referred to as a cyclic (thio)ether compound), such as polyfunctional epoxy compounds (F-1), polyfunctional oxetane compounds (F-2), and a episulfide resin, prove to be particularly desirable.

As the polyfunctional epoxy compound, for example, bisphenol A type epoxy resins represented by EPIKOTE 828, EPIKOTE 834, EPIKOTE 1001, and EPIKOTE 1004 produced by Japan Epoxy Resin K.K., EPICLON 840, EPICLON 850, EPICLON 1050, and EPICLON 2055 produced by Dainippon Ink and Chemicals Inc., Epo Tohto YD-011, YD-013, YD-127, and YD-128 produced by Tohto Kasei Co., Ltd., D.E.R. 317, D.E.R. 331, D.E.R. 661, and D.E.R. 664 produced by The Dow Chemical Company, ARALDITE 6071, ARALDITE 6084, ARALDITE GY250, and ARALDITE GY260 produced by Ciba Specialty Chemicals Inc., Sumi-epoxy ESA-011, ESA-014, ELA-115, and ELA-128 produced by Sumitomo Chemical Co., Ltd., and A.E.R. 330, A.E.R. 331, A.E.R. 661, and A.E.R. 664 produced by Asahi Chemical Industry Co., Ltd. (all trade names); brominated epoxy resins represented by EPIKOTE YL903 produced by Japan Epoxy Resin K.K., EPICLON 152 and EPICLON 165 produced by Dainippon Ink and Chemicals Inc., Epo Tohto YDB-400 and YDB-500 produced by Tohto Kasei Co., Ltd., D.E.R. 542 produced by The Dow Chemical Company, ARALDITE 8011 produced by Ciba Specialty Chemicals Inc., Sumi-epoxy ESB-400 and ESB-700 produced by Sumitomo Chemical Co., Ltd., and A.E.R. 711 and A.E.R. 714 produced by Asahi Chemical Industry Co., Ltd. (all trade names); novolak type epoxy resins represented by EPIKOTE 152 and EPIKOTE 154 produced by Japan Epoxy Resin K.K., D.E.N. 431 and D.E.N. 438 produced by The Dow Chemical Company, EPICLON N-730, EPICLON N-770, and EPICLON N-865 produced by Dainippon Ink and Chemicals Inc., Epo Tohto YDCN-701 and YDCN-704 produced by Tohto Kasei Co., Ltd., ARALDITE ECN1235, ARALDITE ECN1273, ARALDITE ECN1299, and ARALDITE XPY307 produced by Ciba Specialty Chemicals Inc., EPPN-201, EOCN-1025, EOCN-1020, EOCN-1045, and RE-306 produced by Nippon Kayaku Co., Ltd., Sumi-epoxy ESCN-195X and ESCN-220 produced by Sumitomo Chemical Co., Ltd., and A.E.R. ECN-235 and ECN-299 produced by Asahi Chemical Industry Co., Ltd. (all trade names); bisphenol F type epoxy resins represented by EPICLON 830 produced by Dainippon Ink and Chemicals Inc., EPIKOTE 807 produced by Japan Epoxy Resin K.K., Epo Tohto YDF-170, YDF-175, and YDF-2004 produced by Tohto Kasei Co., Ltd., and ARALDITE XPY306 produced by Ciba Specialty Chemicals Inc. (all trade names); hydrogenated bisphenol A type epoxy resins represented by Epo Tohto ST-2004, ST-2007, and ST-3000 produced by Tohto Kasei Co., Ltd. (all trade names); glycidylamine type epoxy resins represented by EPIKOTE 604 produced by Japan Epoxy Resin K.K., Epo Tohto YH-434 produced by Tohto Kasei Co., Ltd., ARALDITE MY720 produced by Ciba Specialty Chemicals Inc., and Sumi-epoxy ELM-120 produced by Sumitomo Chemical Co., Ltd. (all trade names); hydantoin type epoxy resins such as ARALDITE CY-350 produced by Ciba Specialty Chemicals Inc. (trade name); alicyclic epoxy resins represented by Celloxide 2021 produced by Daicel Chemical Industries, Ltd., and ARALDITE CY175 and CY179 produced by Ciba Specialty Chemicals Inc. (all trade names); trihydroxyphenyl methane type epoxy resins represented by YL-933 produced by Japan Epoxy Resin K.K., T.E.N. produced by The Dow Chemical Company, and EPPN-501 and EPPN-502 produced by Nippon Kayaku Co., Ltd. (all trade names); bixylenol type or biphenol type epoxy resins or mixtures thereof represented by YL-6056, YX-4000, and YL-6121 produced by Japan Epoxy Resin K.K. (all trade names); bisphenol S type epoxy resins represented by EBPS-200 produced by Nippon Kayaku Co., Ltd., EPX-30 produced by Asahi Denka Kogyo K.K., and EXA-1514 produced by Dainippon Ink and Chemicals Inc. (all trade names); bisphenol A novolak type epoxy resins represented by EPIKOTE 157S (trade name) produced by Japan Epoxy Resin K.K.; tetraphenylol ethane type epoxy resins represented by EPIKOTE YL-931 produced by Japan Epoxy Resin K.K., and ARALDITE 163 produced by Ciba Specialty Chemicals Inc. (all trade names); heterocyclic epoxy resins represented by ARALDITE PT810 produced by Ciba Specialty Chemicals Inc. and TEPIC produced by Nissan Chemical Industries Ltd. (all trade names); diglycidyl phthalate resin represented by BLEMMER DGT (trade name) produced by Nippon Oil and Fats Co., Ltd.; tetraglycidyl xylenoyl ethane resins represented by ZX-1063 (trade name) produced by Tohto Kasei Co., Ltd.; naphthalene group-containing epoxy resins represented by ESN-190 and ESN-360 produced by Shinnittetsu Chemical Co., Ltd. and HP-4032, EXA-4750, and EXA-4700 produced by Dainippon Ink and Chemicals Inc. (all trade names); dicyclopentadiene skeleton-containing epoxy resins represented by HP-7200 and HP-7200H produced by Dainippon Ink and Chemicals Inc. (all trade names); glycidylmethacrylate copolymer type epoxy resins represented by CP-50S and CP-50M produced by Nippon Oil and Fats Co., Ltd. (all trade names); copolymeric epoxy resin of cyclohexylmaleimide and glycidyl methacrylate; epoxy-modified polybutadiene rubber derivatives (for example, PB-3600 produced by Daicel Chemical Industries, Ltd.), CTBN-modified epoxy resins (for example, YR-102 and YR-450 produced by Tohto Kasei Co., Ltd.) may be cited, but are not limited to these epoxy resins. These epoxy resins may be used either singly or in the form of a combination of two or more members. Among other epoxy resins cited above, novolak type epoxy resins, heterocyclic epoxy resins, bisphenol A type epoxy resins or mixtures thereof prove to be particularly desirable.

As the polyfunctional oxetane compounds (F-2), bis[(3-methyl-3-oxetanylmethoxy)methyl]ether, bis[(3-ethyl-3-oxetanylmethoxy)methyl]ether, 1,4-bis[(3-methyl-3-oxetanylmethoxy)methyl]benzene, 1,4-bis[(3-ethyl-3-oxetanylmethoxy)methyl]benzene, (3-methyl-3-oxetanyl)methyl acrylate, (3-ethyl-3-oxetanyl)methyl acrylate, (3-methyl-3-oxetanyl)methyl methacrylate, (3-ethyl-3-oxetanyl)methyl methacrylate, their oligomers or polymers, and etherified products of an oxetane with a hydroxyl group-containing resin, such as a novolak resin, poly(p-hydroxy styrene), cardo type bisphenols, calixarenes, calixresorcinarenes, or silsesquioxane, may be cited. Besides, copolymers of an unsaturated monomer having an oxetane ring with an alkyl (meth)acrylate may be cited.

As the above-mentioned compound having two or more cyclic thioether groups in its molecule, for example, a bisphenol A type episulfide resin, YL7000 manufactured by the Japan Epoxy Resin K.K. may be cited. Further, an episulfide resin containing a sulfur atom in place of an oxygen atom of an epoxy group of a novolak type epoxy resin obtained by the similar synthetic method may be used.

The amount of such a cyclic (thio)ether compound to be incorporated in the composition is preferred to be such that the cyclic (thio)ether group content in the compound falls in the range of 0.6 to 2.0 equivalent weights, preferably 0.8 to 1.5 equivalent weights per one equivalent weight of the carboxyl group of the carboxyl group-containing resin (A) mentioned above. If the amount of the cyclic (thio)ether compound is less than the lower limit of the range mentioned above, undesirably the carboxyl group will remain in the cured product so that the resistance to heat, the resistance to alkalis and the electrical insulating properties of the cured film will be deteriorated. Conversely, if the amount of the cyclic (thio)ether compound exceeds the upper limit of the range mentioned above, undesirably the cyclic (thio)ether group of a low molecular weight will remain in the cured product so that the strength of the cured film will be deteriorated.

When the cyclic (thio)ether compound is used, it is preferable that the composition should contain a thermosetting catalyst. As such a thermosetting catalyst, for example, imidazole and imidazole derivatives such as 2-methylimidazole, 2-ethylimidazole, 2-ethyl-4-methylimidazole, 2-phenylimidazole, 4-phenylimidazole, 1-cyanoethyl-2-phenylimidazole, and 1-(2-cyanoethyl)-2-ethyl-4-methylimidazole; amine compounds such as dicyandiamide, benzyldimethyl amine, 4-(dimethylamino)-N,N-dimethylbenzyl amine, 4-methoxy-N,N-dimethylbenzyl amine, 4-methyl-N,N-dimethylbenzyl amine; hydrazine compounds such as hydrazide adipate and hydrazide sebacate; and phosphorus compounds such as triphenylphosphine may be cited. As the commercially available thermosetting catalysts, for example, products of Shikoku Chemicals Co., Ltd.; 2MZ-A, 2MZ-OK, 2PHZ, 2P4BHZ, and 2P4MHZ (invariably trade names for imidazole type compounds), and products of Sun-Apro K.K.; U-CAT3503X and U-CAT3502X (invariably trade names for isocyanate compounds blocked with dimethyl amine) and DBU, DBN, U-CATSA102, and U-CAT5002 (invariably trade names for dicyclic amizine compounds and salts thereof) may be cited. The thermosetting catalyst is not limited to the compounds cited above. Any thermosetting catalysts for an epoxy resin and an oxetane compound and any compounds which can promote the reaction of an epoxy group and/or an oxetanyl group with a carboxyl group may be used either singly or in the form of a mixture of two or more members. Furthermore, S-triazine derivatives which also function as an adhesiveness-imparting agent, such as guanamine, acetoguanamine, benzoguanamine, melamine, 2,4-diamino-6-methacryloyloxyethyl-S-triazine, 2-vinyl-4,6-diamino-S-triazine, isocyanuric acid adduct of 2-vinyl-4,6-diamino-S-triazine, isocyanuric acid adduct of 2,4-diamino-6-methacryloyloxyethyl-S-triazine can also be used. Preferably, these compounds which also function as an adhesiveness-imparting agent are used in combination with the thermosetting catalyst mentioned above.

The amount of the thermosetting catalyst to be incorporated in the composition may be sufficient in the conventionally used range, for example, in the range of 0.1 to 20 parts by weight, preferably 0.5 to 15.0 parts by weight, based on 100 parts by weight of the carboxyl group-containing resin (A) or the cyclic (thio)ether compound mentioned above.

The photocurable and thermosetting resin composition of the present invention may use an organic solvent for the synthesis of the carboxyl group-containing resin (A) or preparation of the composition or for the purpose of adjusting the viscosity of the composition to a level suitable for application to a substrate of a carrier film. As such an organic solvent, for example, ketones, glycol ethers, glycol ether acetates, esters, alcohols, aliphatic hydrocarbons, and petroleum solvents may be cited. As concrete examples, ketones such as methylethyl ketone and cyclohexanone; aromatic hydrocarbons such as toluene, xylene, and tetramethyl benzene; glycol ethers such as cellosolve, methyl cellosolve, butyl cellosolve, carbitol, methyl carbitol, butyl carbitol, propylene glycol monomethyl ether, dipropylene glycol monomethyl ether, dipropylene glycol diethyl ether, and triethylene glycol monoethyl ether; glycol ether acetates such as dipropylene glycol methyl ether acetate, propylene glycol methyl ether acetate, propylene glycol ethyl ether acetate, and propylene glycol butyl ether acetate; esters such as ethyl acetate, butyl acetate, and acetates of glycol ethers mentioned above; alcohols such as ethanol, propanol, ethylene glycol, and propylene glycol; aliphatic hydrocarbons such as octane and decane; and petroleum solvents such as petroleum ether, petroleum naphtha, hydrogenated petroleum naphtha, and solvent naphtha may be cited.
These organic solvents may be used either singly or in the form of a mixture of two or more members.

The photocurable and thermosetting resin composition of the present invention may further incorporate therein, as occasion demands, any of known and commonly used coloring agents such as phthalocyanine blue, phthalocyanine green, iodine green, disazo yellow, crystal violet, titanium oxide, carbon black, and naphthalene black, any of known and commonly used thermal polymerization inhibitors such as hydroquinone, hydroquinone monomethyl ether, tert-butyl catechol, pyrogallol, and phenothiazine, any of known and commonly used thickening agents such as finely powdered silica, organobentonite, and montmorillonite, silicone type, fluorine type, or macromolecular type anti-foaming agents and/or leveling agents, adhesiveness-imparting agents or silane coupling agents such as imidazole-based compound, thiazole-based compound, and triazole-based compound, or any other known and commonly used additives.

The photocurable and thermosetting resin composition of the present invention is adjusted to a level of viscosity suitable for a particular coating method by adding an organic solvent mentioned above, for example, applied to a substrate by the technique of a dip coating method, a flow coating method, a roll coating method, a bar coater method, a screen printing method, a curtain coating method, or the like, and then dried (pre-dried) at a temperature in the approximate range of 60 to 100°C to expel by evaporation the organic solvent contained in the composition to produce a tack-free coating film. Alternatively, a resin insulation layer may be formed by laminating on a substrate a film which has been obtained in advance by applying the composition mentioned above onto a carrier film, drying the composition and winding the resultant film to a reel.
The drying by evaporation of the photocurable and thermosetting resin composition of the present invention to be done after applied to a substrate may be performed by the use of a hot air circulating drying oven, an IR oven (infrared heating oven), a hot plate, a convection oven, or the like. Further, a method of contacting the hot air flowing in the counter direction or blowing the hot air through a nozzle onto a substrate in a drying machine equipped with a heat source of an air heating system with steam or any other methods may be adopted.

Thereafter, the resultant coating film is exposed to light (irradiated with an active energy ray), thereby the exposed area (the area irradiated with the active energy ray) cures.
The exposure to light may be done by the direct imaging with a laser beam or the like according to a prescribed pattern or selectively exposing to an active energy ray through a photomask having a prescribed exposure pattern by a contact method (or a non-contact method).
Thereafter, the unexposed area of the coating film, in the state as it is when the exposure to light has been done by the direct imaging with the laser beam or after removing the photomask when it has been used, is developed with a dilute aqueous alkali solution (for example, an aqueous 0.3-3% sodium carbonate solution) to form a resist pattern. When the resultant resist film is further thermally cured by heating to a temperature of about 140-180°C, for example, the carboxyl group of the carboxyl group-containing resin (A) mentioned above reacts with the thermosetting component (F) such as the cyclic (thio)ether compound, and thus a cured film which excels in various properties such as resistance to heat, resistance to chemicals, resistance to moisture absorption, adhesiveness, and electrical properties can be obtained.

As the above-mentioned substrate, copper-clad laminates of all grades (FR-4 etc.) using various materials to be used for the copper-clad laminates for high frequency circuits, such as a paper-phenol resin composite material, a paper-epoxy resin composite material, a glass cloth-epoxy resin composite material, a glass-polyimide composite material, a glass cloth/nonwoven fabric-epoxy resin composite material, a glass cloth/paper-epoxy resin composite material, a synthetic fiber-epoxy resin composite material, and a fluoroplastic-polyethylene-PPO-cyanate ester composite material, and a polyimide film, a PET film, a glass substrate, a ceramic substrate, a wafer substrate, etc. may be cited.

As an exposure machine to be used for irradiation with the active energy ray mentioned above, direct imaging equipment (for example, laser direct imaging equipment which depicts an image directly by a laser with the CAD data from a computer) can be used. As the activity energy ray, either of a gas laser and a solid-state laser may be used insofar as the laser beam having a maximum wavelength falling in the range of 350 nm to 420 nm is used. Although the exposure dose varies depending on the film thickness etc., it may be set generally in the range of 5 to 200 mJ/cm², preferably 5 to 100 mJ/cm², more preferably 5 to 50 mJ/cm². As the above-mentioned direct imaging equipment, the products manufactured by Orbotech Japan Co., Ltd., Hitachi Via Mechanics, Ltd. and PENTAX CORPORATION, for example, may be used. Any equipment may be used insofar as it can emit the laser beam having the maximum wavelength in the range of 350 nm to 420 nm.

As a developing method mentioned above, a dipping method, a shower method, a brushing method or the like may be adopted. As a developing solution, aqueous alkali solutions of potassium hydroxide, sodium hydroxide, sodium carbonate, potassium carbonate, sodium phosphate, sodium silicate, ammonia, amines, etc. may be used. The proper concentration of alkali in the developing solution is generally 0.1 to 5% by weight.
As the light source for irradiation with the active energy ray, besides various laser beams, a low-pressure mercury vapor lamp, a medium-pressure mercury vapor lamp, a high-pressure mercury vapor lamp, an ultra-high-pressure mercury vapor lamp, a xenon lamp, and a metal halide lamp are suitably used. Further, electron beams, α-rays, β-rays, γ-rays, X-rays, neutron beams, etc. may be utilized.

### Examples

Now, the present invention will be more specifically described below with reference to working examples and comparative examples. However, the present invention is not limited to the following examples. Wherever "parts" is mentioned hereinbelow, it invariably refers to that based on weight unless otherwise specified.

### Synthetic Example 1

Into a 2 liter separable flask equipped with a stirrer, a thermometer, a reflux condenser, a dropping funnel, and a nitrogen introduction tube, 660 g of cresol novolak type epoxy resin (EOCN-104S produced by Nippon Kayaku Co., Ltd., a softening point: 92°C, an epoxy equivalent weight: 220), 421.3 g of carbitol acetate, and 180.6 g of solvent naphtha were charged. The mixture was heated and stirred at 90°C until solution. The resin solution consequently obtained was cooled once to 60°C. The cooled solution and 216 g of acrylic acid, 4.0 g triphenyl phosphine, and 1.3 g of methyl hydroquinone added thereto were heated to 100°C and left reacting for about 12 hours to obtain a reaction product having an acid value of 0.2 mg KOH/g. This reaction product and 241.7 g of tetrahydrophthalic anhydride added thereto were heated to 90°C and left reacting for about 6 hours to obtain a solution of a carboxyl group-containing resin (A) having an acid value of 50 mg KOH/g, a double bond equivalent weight (g weight of the resin per 1 mol of an unsaturated group) of 400, and a weight-average molecular weight of 7,000. The solution of this carboxyl group-containing resin will be referred to hereinafter as "A-1 varnish".

### Synthetic Example 2

Into a 2 liter separable flask equipped with a stirrer, a thermometer, a reflux condenser, a dropping funnel, and a nitrogen introduction tube, 430 g of an o-cresol novolak type epoxy resin (epoxy equivalent weight: 215, average number of phenol skeletons contained in its molecule: 6) and 144 g (2 mols) of acrylic acid were charged. The reaction mixture was heated to 120°C while stirring, and the reaction was continued for 10 hours while keeping the temperature at 120°C. The reaction product consequently obtained was cooled once to room temperature. The cooled reaction product and 190 g (1.9 mols) of succinic anhydride added thereto were heated to 80°C and left reacting for 4 hours. The resultant reaction product was again cooled to room temperature. The resultant reaction product had an acid value of 139 mg KOH/g.
This solution and 85.2 g (0.6 mol) of glycidyl methacrylate and 45.9 g of propylene glycol methyl ether acetate added thereto were heated to 110°C while stirring, and the reaction was continued for 6 hours while keeping the temperature at 110°C. After this reaction product was cooled to room temperature, a viscous liquid was obtained. The obtained solution of a carboxyl group-containing resin (A) had a non-volatile content of 65% by weight and an acid value of 86 mg KOH/g as solids. The solution of this carboxyl group-containing resin will be referred to hereinafter as "A-2 varnish".

### Synthetic Example 3

Into a 2 liter separable flask equipped with a stirrer, a thermometer, a reflux condenser, a dropping funnel, and a nitrogen introduction tube, 215 parts of a cresol novolak type epoxy resin EPICLON N-680 (manufactured by Dainippon Ink and Chemicals Inc., epoxy equivalent weight: 215) was charged and then 266.5 parts of carbitol acetate was added thereto and they were molten by heating. To this resin solution, 0.05 part of hydroquinone as a polymerization inhibitor and 1.0 part of triphenyl phosphine as a reaction catalyst were added. The resultant mixture was heated to 85-95°C, 72 parts of acrylic acid was gradually added dropwise thereto, and they were left reacting for 24 hours. To the resultant epoxy acrylate, 208 parts of a half urethane obtained by the reaction of isophorone di-isocyanate and pentaerythritol triacrylate at the molar ratio of 1:1 in advance was gradually added dropwise, and the mixture was left reacting for 4 hours at 60-70°C. The varnish of the resultant epoxy urethane acrylate which is a compound (D) containing two or more ethylenically unsaturated groups in its molecule will be referred to hereinafter as "D-1 varnish".

### Examples 1 to 10 and Comparative Examples 1 and 2

By using the resin solutions obtained in the synthetic examples 1 to 3 mentioned above, the components shown in Table 1 accounting for varying ratios (in parts by weight) of combination shown in Table 1 were compounded, preliminarily mixed with an agitator, and then kneaded with a three-roll mill to obtain photocurable and thermosetting resin compositions. The degree of dispersion of particles in each resultant photocurable and thermosetting resin composition determined by the grain size measurement with a grindometer manufactured by ERICHSEN GmbH was not more than 15 µm.

**[Table 1]**

| Components (parts by weight) | | Examples | | | | | | | | | | Comp. | |
|---|---|---|---|---|---|---|---|---|---|---|---|---|---|
| | | 1 | 2 | 3 | 4 | 5 | 6 | 7 | 8 | 9 | 10 | 1 | 2 |
| A-1 varnish | | 154 | - | - | - | - | - | - | - | - | - | - | - |
| A-2 varnish | | - | 154 | 154 | 154 | 154 | 154 | 154 | 154 | 154 | 154 | 154 | 154 |
| Photopolymerization imtiator(B-1)*¹ | | 1 | 0.5 | 0.7 | 1 | 1 | 0.7 | 0.7 | 3 | 5 | 1 | 1 | - |
| Photopolymerization initiator (B-2)*² | | - | - | - | - | - | 0.3 | - | - | - | - | - | - |
| Photopolymerization initiator (B-3)*³ | | - | - | - | - | - | - | 0.3 | - | - | - | - | - |
| Photopolymerization initiator (C-1)*⁴ | | 6 | 3 | 6 | 6 | 6 | 6 | 6 | 6 | 10 | 6 | - | 15 |
| Photopolymerization initiator*⁵ | | 1 | 1 | 1 | 1 | 1 | - | - | 1 | 1 | 1 | 1 | 1 |
| D-1 varnish | | - | - | - | - | - | - | - | - | - | 20 | - | - |
| Compound (D-2) ^{*6} | | 20 | 20 | 20 | 20 | 20 | 20 | 20, | 20 | 20 | 20 | 20 | 20 |
| Compound (D-3) *⁷ | | 10 | 10 | 10 | 10 | 10 | 10 | 10 | 10 | 10 | 10 | 10 | 10 |
| Filler (E-1) *⁸ | | 130 | 130 | 130 | 130 | 130 | 130 | 130 | 130 | 130 | 130 | 130 | 130 |
| Thermosetting component (F-1-1) *⁹ | | 15 | 15 | 15 | 15 | 15 | 15 | 15 | 15 | 15 | 15 | 15 | 15 |
| Thermosetting component (F-1-2) *¹⁰ | | 30 | 30 | 30 | 30 | 30 | 30 | 30 | 30 | 30 | 30 | 30 | 30 |
| Phthalocyanine blue | | 0.3 | 0.3 | 0.3 | 0.3 | 0.3 | 0.3 | 0.3 | 0.3 | 0.3 | 0.3 | 0.3 | 0.3 |
| Yellow pigment*¹¹ | | 0.75 | 0.75 | 0.75 | 0.75 | 0.75 | 0.75 | 0.75 | 0.75 | 0.75 | 0.75 | 0.75 | 0.75 |
| Finely powdered melamine | | 3 | 3 | 3 | 3 | 3 | 3 | 3 | 3 | 3 | 3 | 3 | 3 |
| Silicone-based anti-foaming agent | | 3 | 3 | 3 | 3 | 3 | 3 | 3 | 3 | 3 | 3 | 3 | 3 |
| DPM*¹² | | 5 | 5 | 5 | 5 | 5 | 5 | 5 | 5 | 5 | 5 | 5 | 5 |
| #150*¹³ | | 5 | 5 | 5 | 5 | 5 | 5 | 5 | 5 | 5 | 5 | 5 | 5 |
| Remarks | *1: 2-(Acetyloxyiminomethyl) thioxanthen-9-one | | | | | | | | | | | | |
| | *2: 1,2-Octan-dione, 1-[4-(phenylthio)-, 2-(O-benzoyloxime)] | | | | | | | | | | | | |
| | *3: Ethanone, 1-[9-ethyl-6-(2-methylbenzoyl)-9H-carbazole-3-yl]-, 1-(O-acetyloxime) | | | | | | | | | | | | |
| | *4:2-Methyl-1-[4-(methylthio)phenyl]-2-morpholino-aminopropanone-1 | | | | | | | | | | | | |
| | *5: 2-Isopropyl thioxanthone | | | | | | | | | | | | |
| | *6: Dipentaerythritol hexaacrylate | | | | | | | | | | | | |
| | *7: Trimethylolpropane triacrylate | | | | | | | | | | | | |
| | *8: Barium sulfate (B-30 produced by Sakai Chemical Industry Co., Ltd.) | | | | | | | | | | | | |
| | *9: Phenol novolak type epoxy resin (EPPN-201 produced by Nippon Kayaku Co., Ltd.) | | | | | | | | | | | | |
| | *10: Bixylenol type epoxy resin (YX-4000 produced by Japan Epoxy Resin K.K.) | | | | | | | | | | | | |
| | *11: Anthraquinone-based yellow pigment | | | | | | | | | | | | |
| | *12: Dipropylene glycol methyl ether acetate | | | | | | | | | | | | |
| | *13: Aromatic organic solvent (trade name: Ipzol # 150 produced by Idemitsu Kosan Co., Ltd.) | | | | | | | | | | | | |

### Evaluation of quality:

### <Photo-curing properties in deep portion>

After a substrate having a circuit pattern of line/space of 300/300, copper thickness of 35 µm formed in advance thereon was polished by the use of a buffing roll, washed with water, and dried, each of the photocurable and thermosetting resin compositions of Examples 1-10 and Comparative Examples 1, 2 prepared as described above was applied by a screen printing method onto the substrate. The coating film on the substrate was dried in a hot air circulating drying oven at 80°C for 30 minutes. Thereafter, the coating film was exposed to light by the use of a direct imaging apparatus equipped with a semi-conductor laser unit of a maximum wave length of 350-370 nm. As the exposure pattern, a pattern imaging lines of 20/30/40/50/60/70/80/90/100 µm width in a space area was used. The irradiation dose of the active energy ray was 40 mJ/cm² on the photosensitive resin composition. After exposure to light, the coating film was developed with an aqueous 1 wt.% sodium carbonate solution of 30°C to remove the unexposed areas, thereby forming a pattern on the substrate. Then, the patterned coating film was thermally cured at 150°C for 60 minutes to obtain a cured film.
The minimum remaining line of each cured film of the photocurable and thermosetting resin composition obtained as describe above was measured with a light microscope adjusted to 200 magnification. Further, each cured film was severed at the center portions of lines and the cut surface was planished. The upper part size, the lower part size, and the film thickness of the minimum remaining line of the cured coating film were measured with a light microscope adjusted to 1000 magnification. The evaluation criterion is such that the photo-curing properties in a deep portion is considered to be good as the minimum remaining line becomes small and as the lower part size becomes close to the designed size. The evaluation results are shown in Table 2.

### <Sectional profile>

After a substrate having a circuit pattern of line/space of 300/300, copper thickness of 50 µm formed in advance thereon was polished by the use of a buffing roll, washed with water, and dried, each of the photocurable and thermosetting resin compositions of Examples 1-10 and Comparative Examples 1, 2 prepared as described above was applied by a screen printing method onto the substrate. The coating film on the substrate was dried in a hot air circulating drying oven at 80°C for 30 minutes. Thereafter, the coating film was exposed to light by the use of a direct imaging apparatus equipped with a semi-conductor laser unit of a maximum wave length of 350-370 nm. As the exposure pattern, a pattern imaging lines of 20/30/40/50/60/70/80/90/100 µm width in a space area was used. The irradiation dose of the active energy ray was set at the optimum dose obtained by the optimum dose evaluation mentioned above. After the exposure to light, the coating film was developed with an aqueous 1 wt.% sodium carbonate solution to remove the unexposed areas, thereby forming a pattern on the substrate. Then, the patterned coating film was exposed to ultraviolet light by the use of a high pressure mercury vapor lamp at a dose of 1000 mJ/cm² and thermally cured at 150°C for 60 minutes to obtain a cured film. The cross-section of the line part of the cured film designed to 100 µm was examined.
The profile in this cross-section was evaluated by dividing into 5 patterns of A to E corresponding to Fig. 1 (A) through (E), as schematically shown in Fig. 1. Fig. 1(A) through (E) show the schematic pattern diagrams when caused the following phenomena. Particularly, when the deviation of the line width of the pattern film 2 formed on the substrate 1 from the designed value L is not more than 5µm in both the upper part and lower part of the line, the evaluation is A. The results are shown in Table 2.
Evaluation A: The ideal state with the same width as designed (the state shown in Fig. 1(A)).
Evaluation B: The occurrence of the decrease in the line width in the upper part of the line due to insufficient resistance to development or the like (the state shown in Fig. 1(B)).
Evaluation C: The state with under cut (the state shown in Fig. 1(C)).
Evaluation D: The occurrence of the increase in the line width in the lower part of the line due to halation or the like (the state shown in Fig. 1(D)).
Evaluation E: The occurrence of the increase in the line width in the upper part of the line and the under cut (the state shown in Fig. 1(E)).

### <Photo-curing properties in surface>

After a substrate having a circuit pattern of line/space of 300/300, copper thickness of 35 µm formed in advance thereon was polished by the use of a buffing roll, washed with water, and dried, each of the photocurable and thermosetting resin compositions of Examples 1-10 and Comparative Examples 1, 2 prepared as described above was applied by a screen printing method onto the substrate. The coating film on the substrate was dried in a hot air circulating drying oven at 80°C for 60 minutes. Thereafter, the coating film was exposed to light by the use of a direct imaging apparatus equipped with a semi-conductor laser unit of a maximum wave length of 350-370 nm. The exposure pattern employed was the entire surface exposure. The irradiation dose of the active energy ray was 40 mJ/cm² on the photosensitive resin composition. After exposure to light, the coating film was developed for 60 seconds (30°C, spray pressure 0.2 MPa, an aqueous 1 wt.% sodium carbonate solution) to remove the unexposed areas, thereby forming a pattern on the substrate. Then, the patterned coating film was thermally cured at 150°C for 60 minutes to obtain a cured film.
The photo-curing properties in the surface of the cured coating film obtained as described above was evaluated by the 60° gloss measured with a gloss meter, Microtrigloss (manufactured by BYK-Gardner GmbH). The evaluation criterion is such that the photo-curing properties in the surface is considered to be good when the gloss after development is not less than 50 and to be no good when the gloss after development is less than 50. The evaluation results are shown in Table 2.

### <Heat stability>

Each cured coating film of the photocurable and thermosetting resin compositions of Examples 1-10 and Comparative Examples 1, 2 was formed on the substrate having the copper circuit pattern formed in advance thereon in the same manner as in <Photo-curing properties in surface> mentioned above. The presence or absence of peeling of this cured coating film was confirmed by the use of a light microscope adjusted to 1000 magnification. The evaluation criterion is such that the heat stability is considered to be good when the peeling of the cured coating film did not occur and to be no good when the peeling of the cured coating film occurred regardless of the size and the number of sites of peeling. The evaluation results are shown in Table 2.

### <Absorbance>

The measurement of absorbance was done by the use of an ultraviolet and visible region spectrophotometer (Ubest-V-570DS manufactured by JASCO Corporation) and an integrating spheres equipment (ISN- 470 manufactured by JASCO Corporation).
Each of the photocurable and thermosetting resin compositions of Examples 1-10 and Comparative Examples 1, 2 was applied onto a glass plate with an applicator, and dried in a hot air circulating drying oven at 80°C for 30 minutes to form a dried coating film of the photocurable and thermosetting resin composition on the glass plate.
By the use of the ultraviolet and visible region spectrophotometer and the integrating spheres equipment, the absorbance base line in 500-300 nm was measured with the same glass plate as the glass plate to which the photocurable and thermosetting resin composition was applied. On the other hand, the absorbance of the glass plate with the dried coating film prepared as described above was also measured, and the absorbance of the dried coating film itself was calculated based on the above-mentioned base line to obtain the absorbance in the wavelength of 355 nm of the target light. In order to prevent the deviation of absorbance by the deviation of the applied film thickness, the above-mentioned working was repeated by changing the coating thickness with an applicator into four stages, and the graph showing the relation between the coating thickness and the absorbance in 355nm was prepared. The absorbance of the dried coating film of 25 µm film thickness was calculated from the approximate equation obtained from the graph and considered to be the absorbance of each dried coating film.
The evaluation results are shown in Table 2.

**[Table 2]**

| Properties | | Examples | | | | | | | | | | Comp. Examples | |
|---|---|---|---|---|---|---|---|---|---|---|---|---|---|
| | | 1 | 2 | 3 | 4 | 5 | 6 | 7 | 8 | 9 | 10 | 1 | 2 |
| Photo-curing properties in deep portion | Minimum Line width (µm) | 80 | 70 | 50 | 50 | 60 | 60 | 30 | 50 | 70 | 40 | 90 | 100 or more |
| Sectional profile | | A | D | A | A | D | A | A | C | E | A | B | - |
| Photo-curing properties in surface | 60° Gloss | G | G | G | G | G | G | G | G | G | G | NG | G |
| Thermal stability | Peeling on Circuit | G | G | G | G | G | G | G | G | G | G | NG | G |
| Absorbance | 355nm 25 µm thickness | 0.65 | 0.38 | 0.52 | 0.68 | 0.43 | 0.54 | 0.64 | 1.17 | 1.55 | 0.6 | 0.46 | 1.10 |
| Remarks | G: Good | | | | | | | | | | | | |
| | NG: No good | | | | | | | | | | | | |

As being clear from the results shown in Table 2 mentioned above, the photocurable and thermosetting resin composition of the present invention was capable of exhibiting high photopolymerization characteristics to the laser beam of 350-370 nm, sufficient photo-curing properties in the deep portion, and further excellent photo-curing properties in the surface and heat stability.

Incidentally, the photocurable and thermosetting resin compositions of Examples 1-10 and the photocurable resin compositions containing the similar components to the photocurable and thermosetting resin compositions of Examples 1-10 except the thermosetting ingredients (F-1-1) and (F-1-2) were prepared and cured in the same manner as in the evaluation of the photo-curing properties in surface mentioned above to prepare test substrates. Each test substrate was immersed in a solder bath kept at 260°C for 10 seconds and then subjected to a peel test with a cellophane adhesive tape. As a result, although Examples 1-10 had no problem, in the case of the photocurable resin compositions containing the similar components to the photocurable and thermosetting resin compositions of Examples 1-10 except the thermosetting ingredients (F-1-1) and (F-1-2), swelling and peeling of the cured coating film were produced so that it has been confirmed that they have no sufficient resistance to heat required for a solder resist.

### Examples 11-13 and Comparative Examples 3-5

By using the resin solutions obtained in the synthetic examples 1 to 3 mentioned above, the components shown in Table 3 accounting for varying ratios (in parts by weight) of combination shown in Table 3 were compounded, preliminarily mixed with an agitator, and then kneaded with a three-roll mill to obtain photocurable and thermosetting resin compositions. The degree of dispersion of particles in each resultant photocurable and thermosetting resin composition determined by the grain size measurement with a grindometer manufactured by ERICHSEN GmbH was not more than 15 µm.

**[Table 3]**

| Components (parts by weight) | | Examples | | | Comparative Examples | | |
|---|---|---|---|---|---|---|---|
| | | 11 | 12 | 13 | 3 | 4 | 5 |
| A-1 varnish | | 154.0 | 30.0 | 30.0 | 154.0 | 30.0 | 30.0 |
| A-2 varnish | | - | 125.0 | 125.0 | - | 125.0 | 125.0 |
| polymerization initiator (B-1)*¹ | | 2.0 | 2.0 | 2.0 | 2.0 | 2.0 | 2.0 |
| Photopolymerization initiator (C-1)*² | | 12.0 | 12.0 | 12.0 | - | - | - |
| Photopolymerization initiator*³ | | 1.0 | 1.0 | 1.0 | 1.0 | 1.0 | 1.0 |
| D-1 varnish | | - | - | 20.0 | - | - | 20.0 |
| Compound (D-2)*⁴ | | 20.0 | 20.0 | 20.0 | 20.0 | 20.0 | 20.0 |
| Compound (D-3)*⁵ | | 10.0 | 10.0 | 10.0 | 10.0 | 10.0 | 10.0 |
| Filler (E-1) *⁶ | | 130.0 | 130.0 | 130.0 | 130.0 | 130.0 | 130.0 |
| Thermosetting component (F-1-1)*⁷ | | 15.0 | 15.0 | 15.0. | 15.0 | 15.0 | 15.0 |
| Thermosetting component (F-1-2)*⁸ | | 30.0 | 30.0 | 30.0 | 30.0 | 30.0 | 30.0 |
| Phthalocyanine blue | | 0.3 | 0.3 | 0.3 | 0.3 | 0.3 | 0.3 |
| Yellow pigment*⁹ | | 0.75 | 0.75 | 0.75 | 0.75 | 0.75 | 0.75 |
| Finely powdered melamine | | 3.0 | 3.0 | 3.0 | 3.0 | 3.0 | 3.0 |
| Silicone-based anti-foaming agent | | 3.0 | 3.0 | 3.0 | 3.0 | 3.0 | 3.0 |
| DPM*¹⁰ | | 5.0 | 5.0 | 5.0 | 5.0 | 5.0 | 5.0 |
| #150*¹¹ | | 5.0 | 5.0 | 5.0 | 5.0 | 5.0 | 5.0 |
| Remarks | *1: 2-(Acetyloxyiminomethyl) thioxanthen-9-one | | | | | | |
| | *2: 2-Methyl-1-[4-(methylthio)phenyl]-2-morpholino-aminopropanone-1 | | | | | | |
| | *3: 2-Isopropyl thioxanthone | | | | | | |
| | *4: Dipentaerythritol hexaacrylate | | | | | | |
| | *5: Trimethylolpropane triacrylate | | | | | | |
| | *6: Barium sulfate (B-30 produced by Sakai Chemical Industry Co., Ltd.) | | | | | | |
| | *7: Phenol novolak type epoxy resin (EPPN-201 produced by Nippon Kayaku Co., Ltd.) | | | | | | |
| | *8: Bixylenol type epoxy resin (YX-4000 produced by Japan Epoxy Resin K.K.) | | | | | | |
| | *9: Chlomophthal yellow (produced by Ciba Specialty Chemicals K.K.) | | | | | | |
| | *10: Dipropylene glycol methyl ether acetate | | | | | | |
| | *11: Aromatic organic solvent (trade name: Ipzol #150 produced by Idemitsu Kosan Co., Ltd.) | | | | | | |

### Evaluation of quality:

### <Photo-curing properties in deep portion>

The photo-curing properties in a deep portion of a cured coating film were evaluated in the same manner as in <Photo-curing properties in deep portion> mentioned above except that the photocurable and thermosetting resin compositions of Examples 11-13 and Comparative Examples 3-5 prepared as described above were used and the exposure to light was carried out by the use of a direct imaging apparatus equipped with semi-conductor laser units of maximum wave lengths of 355 nm and 405 nm, respectively. The evaluation results are shown in Table 4.

### <Photo-curing properties in surface>

The photo-curing properties in the surface of a cured coating film were evaluated in the same manner as in <Photo-curing properties in surface> mentioned above except that the photocurable and thermosetting resin compositions of Examples 11-13 and Comparative Examples 3-5 mentioned above were used and the exposure to light was carried out by the use of a direct imaging apparatus equipped with semi-conductor laser units of maximum wave lengths of 355 nm and 405 nm, respectively. The evaluation results are shown in Table 4.

### <Heat stability>

The presence or absence of peeling of a cured coating film was evaluated in the same manner as in < Heat stability> mentioned above except that the photocurable and thermosetting resin compositions of Examples 11-13 and Comparative Examples 3-5 mentioned above were used. The evaluation results are shown in Table 4.

**[Table 4]**

| Properties | | | Examples | | | Comparative Examples | | |
|---|---|---|---|---|---|---|---|---|
| | | | 11 | 12 | 13 | 3 | 4 | 5 |
| 355 nm | Photo-curing Properties in deep portion (µm) | Minimum remaining width | 50 | 50 | 40 | 70 | 70 | 60 |
| | | Upper width | 51 | 51.5 | 40.5 | 71 | 72.5 | 62 |
| | | Lower width | 52.5 | 51 | 41 | 66.5 | 65.5 | 55.5 |
| | | Film thickness | 38.5 | 39 | 38 | 38.5 | 39 | 38.5 |
| | Photo-curing Properties in surface | 60° Gloss | Good | Good | Good | No good | No good | Good |
| | Thermal stability | Absence or presence of Pealing | Good | Good | Good | No good | No good | No good |
| 405 nm | Photo-curing Properties in deep portion (µm) | Minimum remaining width | 40 | 40 | 30 | 60 | 60 | 50 |
| | | Upper width | 42 | 41 | 31.5 | 60.5 | 61 | 51 |
| | | Lower width | 43.5 | 41 | 31 | 56 | 54 | 45 |
| | | Film thickness | 38 | 38.5 | 38.5 | 38 | 39 | 39 |
| | Photo-curing Properties in surface | 60° Gloss | Good | Good | Good | No good | No good | Good |
| | Thermal stability | Absence or presence of Pealing | Good | Good | Good | No good | No good | No good |

As being clear from the results shown in Table 4 mentioned above, the photocurable and thermosetting resin composition of the present invention was capable of exhibiting high photopolymerization characteristics to the laser beam of 350-420 nm, sufficient photo-curing properties in the deep portion, and further excellent photo-curing properties in the surface and heat stability.

By using the photocurable and thermosetting resin compositions of Examples 11-13 mentioned above, the evaluation of quality was done in the same manner as described above by the use of a contact exposure apparatus equipped with a metal halide lamp (GW20 manufactured by ORC Manufacturing Co., Ltd.) in place of the direct imaging apparatus equipped with a semi-conductor laser unit.
The results are shown in Table 5.

**[Table 5]**

| Properties | | | Examples | | |
|---|---|---|---|---|---|
| | | | 11 | 12 | 13 |
| Exposure with metal halide lamp | Photo-curing Properties in deep portion (µm) | Minimum remaining width | 40 | 40 | 40 |
| | | Upper width | 60 | 61 | 67 |
| | | Lower width | 40 | 41 | 42 |
| | | Film thickness | 38 | 38.5 | 38.5 |
| | Photo-curing Properties in surface | 60° Gloss | Good | Good | Good |
| | Thermal stability | Absence or presence of Pealing | Good | Good | Good |

As being clear from the results shown in Table 5 mentioned above, the photo-curing properties in the deep portion of the photocurable and thermosetting resin composition of the present invention exhibited a large difference between the upper part width and the lower part width when a metal halide lamp is used, as compared with the results shown in Table 4. Accordingly, it has been confirmed that the photocurable and thermosetting resin composition of the present invention is suitable for the direct imaging with a laser beam.

### Examples 14-21 and Comparative Examples 6-8

By using the resin solutions obtained in the synthetic examples 1 to 3 mentioned above, the components shown in Table 6 accounting for varying ratios (in parts by weight) of combination shown in Table 6 were compounded, preliminarily mixed with an agitator, and then kneaded with a three-roll mill to obtain photocurable and thermosetting resin compositions. The degree of dispersion of particles in each resultant photocurable and thermosetting resin composition determined by the grain size measurement with a grindometer manufactured by ERICHSEN GmbH was not more than 15 µm.

**[Table 6]**

| Components (parts by weight) | | Examples | | | | | | | | Comp. Examples | | |
|---|---|---|---|---|---|---|---|---|---|---|---|---|
| | | 14 | 15 | 16 | 17 | 18 | 19 | 20 | 21 | 6 | 7 | 8 |
| A-1 varnish | | 125 | 125 | 125 | - | 125 | 125 | 125 | 125 | 125 | 125 | 125 |
| A-2 varnish | | - | - | - | 154 | - | - | - | - | - | - | - |
| Photopolymerization initiator (B-1)*¹ | | 2 | 2 | 2 | 2 | 2 | 2 | 2 | 2 | - | - | 2 |
| Photopolymerization initiator (C-1)*² | | - | 12 | 12 | 12 | 12 | 12 | 12 | 12 | - | 12 | - |
| Photopolymerization initiator (C-2)*³ | | 15 | 10 | 5 | 10 | 5 | 5 | 5 | 5 | 15 | 10 | - |
| Photopolymerization initiator *⁴ | | - | - | 0.6 | - | 0.6 | - | 0.6 | 0.6 | - | 0.6 | - |
| Photopolymerization initiator *⁵ | | - | - | - | - | 0.2 | 0.6 | 0.2 | 1.0 | - | 0.2 | - |
| Phthalocyanine blue | | 0.9 | 0.9 | 0.9 | 0.9 | 0.9 | 0.9 | 0.3 | 0.9 | 0.9 | 0.9 | 0.9 |
| Yellow pigment*⁶ | | 2.3 | 2.3 | 2.3 | 2.3 | 2.3 | 2.3 | 0.7 | 2.3 | 2.3 | 2.3 | 2.3 |
| D-1 varnish | | 20 | 20 | 20 | 20 | 20 | 20 | 20 | 20 | 20 | 20 | 20 |
| Compound (D-2) *⁷ | | 20 | 20 | 20 | 20 | 20 | 20 | 20 | 20 | 20 | 20 | 20 |
| Compound (D-3) *⁸ | | 10 | 10 | 10 | 10 | 10 | 10 | 10 | 10 | 10 | 10 | 10 |
| Filler (E-1) *⁹ | | 130 | 130 | 130 | 130 | 130 | 130 | 130 | 130 | 130 | 130 | 130 |
| Thermosetting component (F-1-1)*¹⁰ | | 15 | 15 | 15 | 15 | 15 | 15 | 15 | 15 | 15 | 15 | 15 |
| Thermosetting component (F-1-2)*¹¹ | | 30 | 30 | 30 | 30 | 30 | 30 | 30 | 30 | 30 | 30 | 30 |
| Finely powdered melamine | | 3 | 3 | 3 | 3 | 3 | 3 | 3 | 3 | 3 | 3 | 3 |
| Silicone-based anti-foaming agent | | 3 | 3 | 3 | 3 | 3 | 3 | 3 | 3 | 3 | 3 | 3 |
| DPM*¹² | | 5 | 5 | 5 | 5 | 5 | 5 | 5 | 5 | 5 | 5 | 5 |
| #150*¹³ | | 5 | 5 | 5 | 5 | 5 | 5 | 5 | 5 | 5 | 5 | 5 |
| Remarks | *1: 2-(Acetyloxyiminomethyl) thioxanthen-9-one | | | | | | | | | | | |
| | *2: 2-Methyl-1-[4-(methylthio)phenyl]-2-morpholino-aminopropanone-1 | | | | | | | | | | | |
| | *3: 2,4,6-trimethylbenzoyl diphenylphosphine oxide | | | | | | | | | | | |
| | *4: 2,4-Diethyl thioxanthone | | | | | | | | | | | |
| | *5: 4,4'-Bisdiethylaminobenzophenone | | | | | | | | | | | |
| | *6: Anthraquinone-based yellow pigment | | | | | | | | | | | |
| | *7: Dipentaerythritol hexaacrylate | | | | | | | | | | | |
| | *8: Trimethylolpropane triacrylate | | | | | | | | | | | |
| | *9: Barium sulfate (B-30 produced by Sakai Chemical Industry Co., Ltd.) | | | | | | | | | | | |
| | *10: Phenol novolak type epoxy resin (EPPN-201 produced by Nippon Kayaku Co., Ltd.) | | | | | | | | | | | |
| | *11: Bixylenol type epoxy resin (YX-4000 produced by Japan Epoxy Resin K.K.) | | | | | | | | | | | |
| | *12: Dipropylene glycol methyl ether acetate | | | | | | | | | | | |
| | *13: Aromatic organic solvent (trade name: Ipzol #150 produced by Idemitsu Kosan Co., Ltd.) | | | | | | | | | | | |

### Evaluation of quality:

### <Photo-curing properties in surface>

The photo-curing properties in the surface of a cured coating film were evaluated in the same manner as in <Photo-curing properties in surface> mentioned above except that the photocurable and thermosetting resin compositions of Examples 14-21 and Comparative Examples 6-8 mentioned above were used and the exposure to light was carried out by the use of a direct imaging apparatus equipped with blue purple region laser of a maximum wave length of 400-420 nm. The evaluation results are shown in Table 7.

### <Sectional profile>

The profile in cross-section of a cured coating film was evaluated in the same manner as in <Sectional profile> mentioned above except that the photocurable and thermosetting resin compositions of Examples 14-21 and Comparative Examples 6-8 mentioned above were used and the exposure to light was carried out by the use of a direct imaging apparatus equipped with blue purple region laser of a maximum wave length of 405 nm. The evaluation results are shown in Table 7.

### <Heat stability>

The presence or absence of peeling of a cured coating film was evaluated in the same manner as in < Heat stability> mentioned above except that the photocurable and thermosetting resin compositions of Examples 14-21 and Comparative Examples 6-8 mentioned above were used. The evaluation results are shown in Table 7.

### <Absorbance>

The measurement of absorbance was done by the use of an ultraviolet and visible region spectrophotometer (Ubest-V-570DS manufactured by JASCO Corporation) and an integrating spheres equipment (ISN- 470 manufactured by JASCO Corporation).
Each of the photocurable and thermosetting resin compositions of Examples 14-21 and Comparative Examples 6-8 was applied onto a glass plate with an applicator, and dried in a hot air circulating drying oven at 80°C for 30 minutes to form a dried coating film of the photocurable and thermosetting resin composition on the glass plate.
By the use of the ultraviolet and visible region spectrophotometer and the integrating spheres equipment, the absorbance base line in 500-300 nm was measured with the same glass plate as the glass plate to which the photocurable and thermosetting resin composition was applied. On the other hand, the absorbance of the glass plate with the dried coating film prepared as described above was also measured, and the absorbance of the dried coating film itself was calculated based on the above-mentioned base line to obtain the absorbance in the wavelength of 405 nm of the target light. In order to prevent the deviation of absorbance by the deviation of the applied film thickness, the above-mentioned working was repeated by changing the coating thickness with an applicator into four stages, and the graph showing the relation between the coating thickness and the absorbance in 405 nm was prepared. The absorbance of the dried coating film of 25 µm film thickness was calculated from the approximate equation obtained from the graph and considered to be the absorbance of each dried coating film.
The evaluation results are shown in Table 7.

**[Table 7]**

| Properties | Examples | | | | | | | | Comp. Examples | | |
|---|---|---|---|---|---|---|---|---|---|---|---|
| | 14 | 15 | 16 | 17 | 18 | 19 | 20 | 21 | 6 | 7 | 8 |
| Photo-curing Properties in surface | Δ | ○ | ○ | ○ | ○ | ○ | Δ | ○ | × | × | Δ |
| Sectional profile | A | A | A | A | A | A | D | C | B | C | E |
| Thermal stability | ○ | ○ | ○ | ○ | ○ | ○ | ○ | ○ | ○ | ○ | × |
| 405nm Absorbance (25 µm thickness) | 0.64 | 0.66 | 0.77 | 0.67 | 0.83 | 0.84 | 0.40 | 1.26 | 0.56 | 0.75 | 0.61 |

As being clear from the results shown in Table 7 mentioned above, the photocurable and thermosetting resin composition of the present invention was capable of exhibiting high photopolymerization characteristics to the laser beam of 400-420 nm, sufficient photo-curing properties in the deep portion, and further excellent photo-curing properties in the surface and heat stability.

### Industrial Applicability

The photocurable and thermosetting resin composition of the present invention excels in the photo-curing properties in a deep portion of a coating and is capable of forming a pattern without causing halation and under cut thereof by means of a laser emission source of the wave length of 350-420 nm. Accordingly, it can be used as a resist material for the laser direct imaging and is useful as a solder resist of printed circuit boards or the like and an insulating resin layer of various electronic parts.

## Claims

1. A photocurable and thermosetting resin composition capable of being developed with a dilute alkaline solution and cured with a laser emission source having a maximum wavelength of 350 nm to 420 nm, comprising (A) a carboxyl-group containing resin, (B) an oxime ester-based photopolymerization initiator containing an oxime ester group represented by the following general formula (I), (C) an aminoacetophenone-based photopolymerization initiator (C-1) containing the structure represented by the following general formula (II) and/or a phosphine oxide-based photopolymerization initiator (C-2) containing the structure represented by the following general formula (III), (D) a compound having at least two ethylenically unsaturated groups in its molecule, (E) a filler, and (F) a thermosetting component. 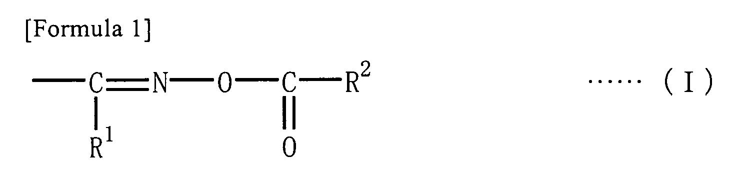 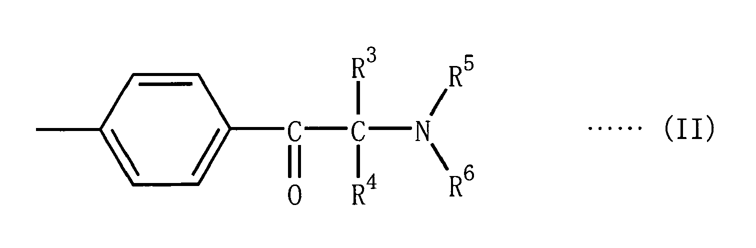 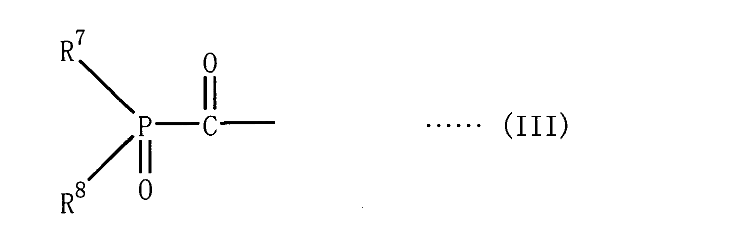 wherein R¹ represents a hydrogen atom, an alkyl group of 1-7 carbon atoms, or a phenyl group, R² represents an alkyl group of 1-7 carbon atoms or a phenyl group, R³ and R⁴ independently represent an alkyl group of 1-12 carbon atoms or an arylalkyl group, R⁵ and R⁶ independently represent a hydrogen atom, an alkyl group of 1-6 carbon atoms, or a cyclic alkyl ether group of four carbon atoms formed by R⁵ and R⁶ bonded, and R⁷ and R⁸ independently represent a linear or branched alkyl group of 1-6 carbon atoms, a cyclohexyl group, a cyclopentyl group, an aryl group, a halogen atom, an aryl group substituted by an alkyl group or an alkoxy group, or either one represents an acyl group of 1-20 carbon atoms.

2. A photocurable and thermosetting resin composition capable of being developed with a dilute alkaline solution and cured with a laser emission source having the maximum wavelength of 350 to 370 nm, comprising (A) a carboxyl-group containing resin, (B) an oxime ester-based photopolymerization initiator containing an oxime ester group represented by the following general formula (I), (C-1) an aminoacetophenone-based photopolymerization initiator containing the structure represented by the following general formula (II), (D) a compound having at least two ethylenically unsaturated groups in its molecule, (E) a filler, and (F) a thermosetting component. 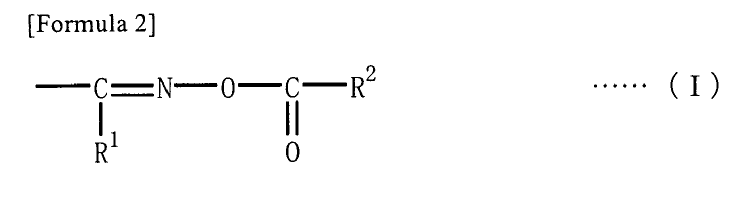 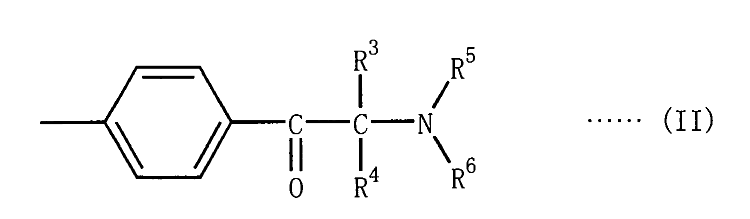 wherein R¹ represents a hydrogen atom, an alkyl group of 1-7 carbon atoms, or a phenyl group, R² represents an alkyl group of 1-7 carbon atoms or a phenyl group, R³ and R⁴ independently represent an alkyl group of 1-12 carbon atoms or an arylalkyl group, and R⁵ and R⁶ independently represent a hydrogen atom, an alkyl group of 1-6 carbon atoms, or a cyclic alkyl ether group of four carbon atoms formed by R⁵ and R⁶ bonded.

3. The photocurable and thermosetting resin composition according to claim 2, wherein the absorbance at a wavelength of 355 nm per 25 µm thickness of a dried coating film is in the range of 0.3-1.5.

4. A photocurable and thermosetting resin composition capable of being developed with a dilute alkaline solution and cured with a laser emission source having a maximum wavelength of 400 to 420 nm, comprising (A) a carboxyl-group containing resin, (B) an oxime ester-based photopolymerization initiator containing an oxime ester group represented by the following general formula (I), (C-2) a phosphine oxide-based photopolymerization initiator containing the structure represented by the following general formula (III), (D) a compound having at least two ethylenically unsaturated groups in its molecule, (E) a filler, and (F) a thermosetting component. 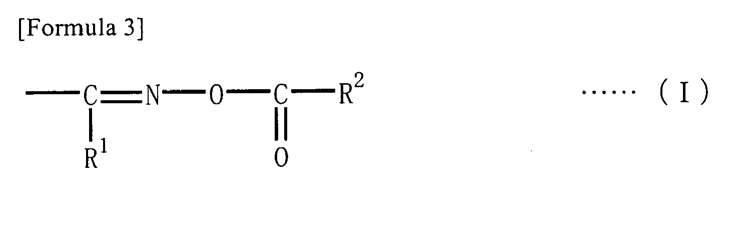 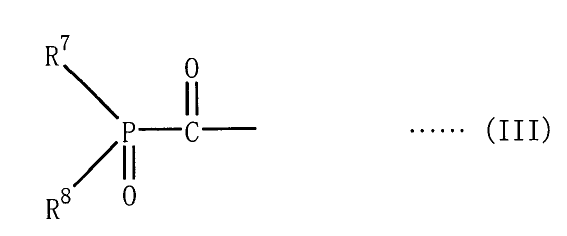 wherein R¹ represents a hydrogen atom, an alkyl group of 1-7 carbon atoms, or a phenyl group, R² represents an alkyl group of 1-7 carbon atoms or a phenyl group, and R⁷ and R⁸ independently represent a linear or branched alkyl group of 1-6 carbon atoms, a cyclohexyl group, a cyclopentyl group, an aryl group, a halogen atom, an aryl group substituted by an alkyl group or an alkoxy group, or either one represents an acyl group of 1-20 carbon atoms.

5. The photocurable and thermosetting resin composition according to claim 4, wherein the absorbance at a wavelength of 405 nm per 25 µm thickness of a dried coating film is in the range of 0.3-1.5.

6. The photocurable and thermosetting resin composition according to any one of claims 1 to 5, wherein said carboxyl group-containing resin (A) is a carboxyl group-containing photosensitive resin obtained by causing (a) a polyfunctional epoxy compound to react with (b) an unsaturated monocarboxylic acid, then causing (c) a polybasic acid anhydride to react with a resultant product, and then further causing (d) a compound having one oxirane ring and one or more ethylenically unsaturated groups in its molecule to react with a carboxyl group-containing resin obtained by said reaction.

7. The photocurable and thermosetting resin composition according to any one of claims 1 to 6, wherein said compound (D) having at least two ethylenically unsaturated groups in its molecule is an epoxy acrylate-based resin.

8. The photocurable and thermosetting resin composition according to any one of claims 1 to 7, wherein said oxime ester-based photopolymerization initiator (B) is a photopolymerization initiator represented by the following formula (IV).

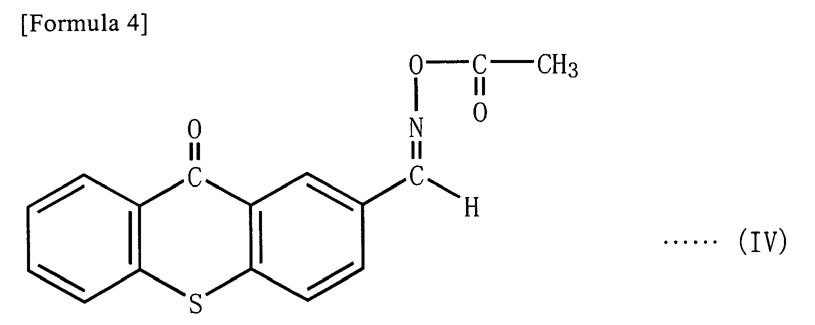

9. The photocurable and thermosetting resin composition according to any one of claims 1 to 8, further comprising (G) a thioxanthone-based photopolymerization initiator.

10. The photocurable and thermosetting resin composition according to any one of claims 1 to 9, which is used as an insulating layer to be formed on a copper circuit.

11. A photocurable and thermosetting dry film obtained by applying the photocurable and thermosetting resin composition according to any one of claims 1 to 10 on a carrier film and drying it.

12. A cured product obtained by photo-curing the photocurable and thermosetting resin composition according to any one of claims 1 to 10 or the dry film according to claim 11 on copper.

13. A cured product obtained by photo-curing the photocurable and thermosetting resin composition according to any one of claims 1 to 10 or the dry film according to claim 11 with a laser emission source.

14. A cured product obtained by photo-curing the photocurable and thermosetting resin composition according to any one of claims 1 to 10 or the dry film according to claim 11 with a laser beam having a wavelength of 350-420 nm and then thermally curing it.

15. A printed circuit board having a cured product obtained by photo-curing the photocurable and thermosetting resin composition according to any one of claims 1 to 10 or the dry film according to claim 11 with a laser beam having a wavelength of 350-420 nm and then thermally curing it.
